# EUROPÄISCHE PATENTSCHRIFT

(11) **EP 3 213 007 B1**
(45) Veröffentlichungstag und Bekanntmachung des Hinweises auf die Patenterteilung: **26.12.2018**
(21) Anmeldenummer: 15788009.7
(22) Anmeldetag: 30.10.2015
(51) Int. Cl.: F24S 23/74, F24S 30/425, F24S 20/55

(54) **VORRICHTUNG ZUR KONZENTRATION VON SONNENSTRAHLUNG MIT AUFBLASBAREM KONZENTRATORKISSEN**
DEVICE FOR THE CONCENTRATION OF SOLAR RADIATION WITH INFLATABLE CONCENTRATOR CUSHION
DISPOSITIF DE CONCENTRATION DU RAYONNEMENT SOLAIRE AVEC COUSSIN GONFLABLE DE CONCENTRATION

(30) Priorität: 31.10.2014 EP 14191252
(43) Veröffentlichungstag der Anmeldung: 06.09.2017
(73) Patentinhaber: Heliovis AG, 2351 Wiener Neudorf (AT)
(72) Erfinder: STÖGER, Elmar, 2351 Wiener Neudorf (AT); TIEFENBACHER, Felix, 2351 Wiener Neudorf (AT)
(74) Vertreter: Sonn & Partner Patentanwälte
(86) Internationale Anmeldenummer: PCT/EP2015/075197
(87) Internationale Veröffentlichungsnummer: WO 2016/066781

(56) Entgegenhaltungen:
- WO-A1-2012/083321
- WO-A1-2013/074790
- WO-A2-2012/145774
- CH-A2- 704 394
- US-A1- 2010 229 850
- US-A1- 2011 277 815

## Beschreibung

Die Erfindung betrifft eine Vorrichtung zur Konzentration von Sonnenstrahlung in einem Absorber, mit einem aufblasbaren Konzentrator-Kissen, welches ein Deckfolienelement mit einem lichtdurchlässigen Eintrittsfenster zum Einkoppeln von Sonnenstrahlung und eine das Konzentrator-Kissen in zumindest zwei Hohlräume unterteilende Reflektorfolie zum Konzentrieren der Sonnenstrahlung in einem Absorber aufweist, mit einer Schwenkeinrichtung, mit welcher das Konzentrator-Kissen insbesondere um dessen Längsachse verschwenkbar ist, und mit einer an der Schwenkeinrichtung montierten Halteeinrichtung zur Halterung des Konzentrator-Kissens, welche Halteeinrichtung einen in Längsrichtung des Konzentrator-Kissens erstreckten oberen Längsträger zur Aufhängung des Absorbers aufweist, wobei der obere Längsträger an einer im Wesentlichen luftdicht verschlossenen oberen Durchtrittsöffnung des Konzentrator-Kissens angeordnet ist.

Aus der WO 2012/145774 ist eine gattungsgemäße Vorrichtung zur Konzentration von Sonnenstrahlung in einem Absorber bekannt geworden. Die Vorrichtung weist einen aufblasbaren Konzentrator auf, welcher durch eine langgestreckte, im Wesentlichen zylindrische schlauchförmige Hülle aus mehreren Folienelementen gebildet ist. Das Kissen weist an der Oberseite ein transparentes Eintrittsfenster zum Durchtritt von Sonnenstrahlung auf. Weiters ist eine Reflektorfolie vorgesehen, mit welcher das Kissen in zumindest zwei getrennte Druckräume unterteilt wird. Die Reflektorfolie weist eine Spiegelfläche auf, mit welcher die eingekoppelte Sonnenstrahlung in Richtung eines Absorbers gebündelt wird. Zur Verankerung des Konzentrators ist ein Verankerungsgerüst vorgesehen. Das Verankerungsgerüst weist ein Nachführungssystem bestehend aus mehreren Nachführungsringen auf, um den kissenförmigen Konzentrator dem Sonnenlauf nachzuführen. Bei der bekannten Ausführung wird der Absorber mittels einer langgestreckten Absorberaufhängung an dem Verankerungsgerüst aufgehängt. Die Absorberaufhängung tritt im Bereich des Eintrittsfensters durch eine Befestigungsöffnung des Konzentrator-Kissens hindurch. Um einen Luftaustritt aus dem Konzentrator-Kissen zu verhindern, ist die Befestigungsöffnung allseitig abgedichtet. Zu diesem Zweck wurde ein Kedersystem vorgesehen, bei welchem an die Befestigungsöffnung angrenzende Abschnitte des Konzentrator-Kissens um einen Keder umgeschlagen und mittels innen- und außenseitig an dem Konzentrator-Kissen angeordneter Klemmplatten der Absorberaufhängung fixiert werden. Demnach ist das Konzentrator-Kissen im Bereich der Befestigungsöffnung fest mit der Absorberaufhängung verbunden, wobei am Konzentrator-Kissen angreifende Kräfte über die Absorberaufhängung abgetragen werden. Diese Ausführung hat sich grundsätzlich als sehr vorteilhaft erwiesen, um das Konzentrator-Kissen in der gewünschten Stellung zu halten. Bei Langzeitversuchen wurde jedoch beobachtet, dass der Wirkungsgrad der Energieumwandlung im Betrieb des Konzentrator-Kissens mit der Zeit abnahm.

Andersartige Reflektoren bzw. Konzentratoren werden in den WO 2012/083321 A1, CH 704 394 A2, US 2010/229850 A1, US 2011/277815 A1 und WO 2013/074790 A1 beschrieben.

Demgegenüber liegt die Aufgabe der vorliegenden Erfindung darin, die Nachteile des Standes der Technik zu beseitigen bzw. zu lindern. Die Erfindung setzt sich daher insbesondere zum Ziel, eine Vorrichtung der eingangs angeführten Art zu schaffen, mit welcher der Wirkungsgrad des Konzentrator-Kissens im Dauerbetrieb weitgehend beibehalten werden kann.

Diese Aufgabe wird durch eine Vorrichtung mit den Merkmalen von Anspruch 1 gelöst. Bevorzugte Ausführungen sind in den abhängigen Ansprüchen angegeben.

Erfindungsgemäß ist zwischen dem oberen Längsträger der Halteeinrichtung und der Schwenkeinrichtung eine Verstelleinrichtung vorgesehen, mit welcher der Abstand zwischen dem oberen Längsträger und der Schwenkeinrichtung einstellbar ist.

Der Wirkungsgrad des langgestreckten, im Querschnitt vorzugsweise im Wesentlichen zylindrischen Konzentrator-Kissens wird durch eine Vielzahl von Faktoren beeinflusst, welche sich zudem auf komplexe Weise überlagern. Bei umfangreichen Tests hat sich jedoch überraschend herausgestellt, dass der Wirkungsgrad des Konzentrator-Kissens bei dauerhafter Nutzung weitgehend beibehalten werden kann, wenn eine Höhenverstellung des oberen Längsträgers, bezogen auf dessen Betriebsposition, vorgenommen wird. Es wurde beobachtet, dass die (Kunststoff-)Materialien des Konzentrator-Kissens zum Kriechen neigen. Dies betrifft insbesondere das Kunststoffmaterial des Deckfolienelements, welches vorzugsweise aus Ethylen-Tetrafluorethylen (ETFE) gefertigt ist. Das Kriechen des Kunststoffmaterials wirkt sich auf die Kraftübertragung zwischen dem Deckfolienelement des Konzentrator-Kissens und dem oberen Längsträger aus, wobei eine Kraftkomponente in vertikaler Richtung auf den oberen Längsträger hervorgerufen wird, welche eine Aufwölbung des oberen Längsträgers bewirkt. Dadurch wird der am oberen Längsträger im oberen Hohlraum des Konzentrator-Kissens aufgehängte Absorber zumindest teilweise außerhalb des Fokusbereiches der Reflektorfolie angeordnet. Dies wirkt sich nachteilig auf den Wirkungsgrad der Energieumwandlung aus. Durch die manuelle oder automatische Verstellung des oberen Längsträgers in Bezug auf die Schwenkeinrichtung kann die im Wesentlichen horizontale Ausrichtung des oberen Längsträgers dauerhaft gewährleistet werden. Dadurch kann der Absorber zuverlässig im Fokus der gewölbten Reflektorfolie zwischen den Druckräumen des Konzentrator-Kissens angeordnet werden, selbst wenn das Kunststoffmaterial des Deckfolienelements einem Alterungs- bzw. Kriechprozess unterliegt. Die Verstelleinrichtung kann mit geringem Aufwand zwischen der Schwenk- und der Halteeinrichtung montiert werden, so dass der Fertigungsaufwand hierdurch kaum erhöht wird. Demnach kann der Wirkungsgrad des Konzentrator-Kissens durch die Anordnung der Verstelleinrichtung wesentlich kostengünstiger als durch andere Maßnahmen, wie die Verwendung steiferer Halteeinrichtungen, gesteigert werden. Dadurch können die Fertigungskosten besonders gering gehalten werden.

Gemäß einer besonders bevorzugten Ausführungsform weist der obere Längsträger zumindest zwei in Längsrichtung des Konzentrator-Kissens erstreckte, insbesondere über Füllstäbe miteinander verbundene Längsgurte auf, welche jeweils mit einem die obere Durchtrittsöffnung begrenzenden Längsrand des Deckfolienelements verbunden sind, wobei die Verstelleinrichtung mit einem der Längsgurte des oberen Längsträgers, vorzugsweise mit beiden Längsgurten des oberen Längsträgers, verbunden ist. Wie beim Stand der Technik der WO 2012/145774 tritt die Halteeinrichtung durch eine allseitig abgedichtete Durchtrittsöffnung des Konzentrator-Kissens hindurch, wobei der Absorber im oberen Hohlraum des Konzentrator-Kissens an dem oberen Längsträger der Halteeinrichtung aufgehängt ist. Im Unterschied dazu weist der erfindungsgemäße Längsträger jedoch zumindest zwei langgestreckte Längsgurte auf, welche bezogen auf die Umfangsrichtung des Konzentrator-Kissens in einem Abstand zueinander angeordnet sind. Zwischen den Längsgurten ist bevorzugt ein die obere Durchtrittsöffnung des Konzentrator-Kissens überbrückender Dichtfolienstreifen vorgesehen. Die Längsgurte sind bei dieser Ausführung einerseits im Wesentlichen luftdicht mit den an die obere Durchtrittsöffnung angrenzenden Längsrändern des Deckfolienelements verbunden. Andererseits sind die Längsgurte im Wesentlichen luftdicht mit den seitlichen Randbereichen des Dichtfolienstreifens verbunden, welches sich zwischen den Längsgurten bevorzugt im Wesentlichen über die gesamte Breite der Durchtrittsöffnung erstreckt. Zur Ausbildung der Längsgurte sind bevorzugt Stabelemente vorgesehen, welche insbesondere einen im Wesentlichen kreisförmigen Querschnitt aufweisen. Durch die Anordnung des Dichtfolienstreifens wird die Durchtrittsöffnung zwischen den Längsgurten des oberen Längsträgers im Wesentlichen luftdicht verschlossen, so dass die Verbindung zwischen den Längsgurten des oberen Längsträgers selbst nicht luftdicht ausgeführt sein muss. Die Ausführung weist gegenüber dem Stand der Technik eine Reihe von Vorteilen auf. Wesentlich ist zunächst, dass die Ausführung des oberen Längsträgers mit zwei Längsgurten für zwei Verbindungen zwischen dem Längsträger und dem Konzentrator-Kissen eingerichtet ist. Dadurch können die im Betrieb am Konzentrator-Kissen angreifende Kräfte, beispielsweise Windkräfte, besonders effizient aufgenommen werden. Vorteilhaft ist insbesondere, dass der kissen- bzw. schlauchförmige Konzentrator im Betrieb weitgehend frei von Verformungen gehalten werden kann. Dadurch kann die konkave Wölbung der Reflektorfolie zwischen dem oberen und dem unteren Hohlraum des Konzentrators präzise eingehalten werden, so dass die Fokussierung der Sonnenstrahlung am Absorber mit hohem Wirkungsgrad erfolgt. Zur Aufnahme von Betriebslasten ist es besonders vorteilhaft, wenn die Längsgurte die äußeren Längsränder des oberen Längsträgers bilden, so dass die Breite des oberen Längsträgers im Wesentlichen der Breite der Durchtrittsöffnung entspricht. Aufgrund der günstigen Krafteinleitung in den oberen Längsträger kann zudem eine gewichtssparende Ausführung erzielt werden, wobei insbesondere auf die beim Stand der Technik vorgesehenen Klemmplatten zum Festklemmen der Kedern verzichtet werden kann. Weiters bringt der Dichtfolienstreifen zwischen den gegenüberliegenden Längsrändern des Deckfolienelements den Vorteil mit sich, dass die Durchtrittsöffnung zuverlässig im Wesentlichen luftdicht verschlossen werden kann, wobei die Ausführung als Folienelement, d.h. als biegsames Element insbesondere aus einem Kunststoffmaterial, eine Gewichtsersparnis bewirkt. Besonders vorteilhaft ist zudem, dass der Dichtfolienstreifen für den Eintritt der Sonnenstrahlung in den Konzentrator optimal geeignet ist, wobei der Dichtfolienstreifen durch den Druck im oberen Hohlraum bevorzugt in einem nach außen gewölbten, gespannten Zustand vorliegt.

Um den oberen Längsträger in der Höhe verstellbar an der Schwenkeinrichtung festzulegen, ist es von Vorteil, wenn die Verstelleinrichtung mit einem der Längsgurte des oberen Längsträgers, vorzugsweise mit beiden Längsgurten des oberen Längsträgers, verbunden ist.

Um den Wirkungsgrad des Konzentrators zu erhöhen, ist es vorteilhaft, wenn der Dichtfolienstreifen aus einem transparenten Kunststoffmaterial, insbesondere aus Ethylen-Tetrafluorethylen (ETFE), besteht. Demnach setzt der Dichtfolienstreifen vorzugsweise im Wesentlichen unterbrechungsfrei das transparente Eintrittsfenster des Deckfolienelementes fort, welches sich auf beiden Seiten der oberen Durchtrittsöffnung des Konzentrator-Kissens erstreckt. Auf diese Weise kann Sonnenstrahlung durch den Dichtfolienstreifen zum Absorber gelangen, welcher im oberen Hohlraum des Konzentrator-Kissens an dem oberen Längsträger aufgehängt ist. Vorzugsweise sind das Deckfolienelement mit dem Eintrittsfenster und der Dichtfolienstreifen aus demselben Material gebildet. Dadurch kann der Wirkungsgrad für die Umwandlung der Sonnenenergie erhöht werden.

Um die Stabilität des oberen Längsträgers zu steigern, ist es von Vorteil, wenn der obere Längsträger zumindest zwei weitere Längsgurte aufweist, welche parallel zu den Längsgurten in Längsrichtung des Konzentrator-Kissens erstreckt sind. Bevorzugt weist der obere Längsträger einen im Wesentlichen rechteckigen, insbesondere im Wesentlichen quadratischen Querschnitt auf, wobei die oberen Ecken durch die Längsgurte und die unteren Ecken durch die weiteren Längsgurte gebildet sind. Für die Zwecke dieser Offenbarung beziehen sich die Begriffe "oben" und "unten" stets auf die Betriebsstellung der Vorrichtung.

Zur Erzielung eines maximalen Volumens des Konzentrator-Kissens innerhalb der Schwenkeinrichtung ist es vorteilhaft, wenn die weiteren Längsgurte des oberen Längsträgers innerhalb des oberen Hohlraums des Konzentrator-Kissens angeordnet sind. Bei dieser Ausführung erstrecken sich die Längsgurte bevorzugt in der Ebene des Deckfolienelements, wohingegen die weiteren Längsgurte in dem oberen Hohlraum des Konzentrator-Kissens angeordnet sind. Vorteilhafterweise kann so das zur Verfügung stehende Einbauvolumen innerhalb der Schwenkeinrichtung optimal genützt werden.

Zur Ausbildung des oberen Längsträgers als Fachwerkträger ist es günstig, wenn die Längsgurte des oberen Längsträgers über Füllstäbe miteinander verbunden sind, wobei vorzugsweise weitere Füllstäbe zwischen den Längsgurten und den weiteren Längsgurten vorgesehen sind. Es hat sich überraschend herausgestellt, dass die aus dem Bauwesen an sich bekannte Ausbildung des oberen Längsträgers als Fachwerkträger für die erfindungsgemäße Anwendung bei dem Konzentrator-Kissen besondere Vorteile birgt. Erstens können die Längsränder des Deckfolienelements auf einfache und zuverlässige Weise im Wesentlichen luftdicht an die Längsgurte des fachwerkartigen oberen Längsträgers angeschlossen werden. Zweitens kann das Sonnenlicht zwischen den Längsgurten und den Füllstäben in das Konzentrator-Kissen eintreten, wodurch die zur Verfügung stehende Lichtmenge für die Fokussierung im Absorber erhöht wird. Drittens sind solche Fachwerkträger in verschiedensten Dimensionen kostengünstig verfügbar, wodurch die Herstellungskosten für den Konzentrator verringert werden können. Viertens ermöglicht die Ausgestaltung des oberen Längsträgers als Fachwerkträger eine optimale Aussteifung des Konzentrator-Kissens in dessen Längsrichtung, wodurch die Auswirkungen von äußeren Einflüssen auf die Geometrie des Konzentrator-Kissens, insbesondere auf die konkave Wölbung der Reflektorfolie, gering gehalten werden können.

Um das Konzentrator-Kissen an den oberen Längsträger anzuschließen, ist es günstig, wenn an den Längsgurten des oberen Längsträgers jeweils ein Profilelement angeordnet ist, welches auf der einen Seite mit einem Verbindungselement zur im Wesentlichen luftdichten Verbindung mit einem der Längsränder des Deckfolienelements und auf der anderen Seite mit einem weiteren Verbindungselement zur im Wesentlichen luftdichten Verbindung mit einem der Längsränder des Dichtfolienstreifens verbunden ist. Die Profilelemente sind vorzugsweise an den Oberseiten der Längsgurte vorgesehen, wobei sich die Verbindungselemente in Längsrichtung der Längsgurte erstrecken.

Hinsichtlich einer stabilen, kostengünstigen Ausführung ist es von Vorteil, wenn die Profilelemente einteilig mit den Längsgurten des oberen Längsträgers gebildet sind. Bei dieser Ausführung sind daher die Profilelemente in den oberen Längsträger integriert. Gemäß einer weniger bevorzugten Ausführung liegen die Profilelemente als gesonderte Bauteile vor, welche an den Längsgurten befestigt werden.

Zur Abdichtung der Verbindung zwischen dem oberen Längsträger und dem Konzentrator-Kissen ist es günstig, wenn als Verbindungselement eine Kederschiene vorgesehen ist, in welcher ein Kederelement an einem der Längsränder des Deckfolienelements angeordnet ist. Bei dieser Ausführung ist daher als Dichtmittel zwischen dem Konzentrator-Kissen und dem oberen Längsträger eine Kedereinrichtung vorgesehen, welche durch die Kederelemente und die entsprechenden Kederschienen gebildet ist. Die Kederelemente erstrecken sich über die Länge der Längsränder des Deckfolienelements. An den Längsgurten des oberen Längsträgers sind entsprechende Kederschienen vorgesehen, welche sich in Längsrichtung des oberen Längsträgers und damit parallel zu den Längsrändern des Deckfolienelements erstrecken. Das Kederelement weist einen größeren Querschnitt als das Deckfolienelement auf, wobei das Kederelement vorzugsweise mit einem runden, insbesondere kreisförmigen, Querschnitt ausgebildet ist. Durch den Druck im oberen Hohlraum des Konzentrator-Kissens liegt das Deckfolienelement in einem gespannten Zustand vor, so dass die Kederelemente an den Längsrändern des Deckfolienelements gegen die Innenwände der Kederschienen gedrückt werden. Dadurch wird eine im Wesentlichen luftdichte Anbindung des Konzentrator-Kissens an den oberen Längsträger erzielt, welche sich als besonders zuverlässig erwiesen hat.

Um den Dichtfolienstreifen auf entsprechende Weise im Wesentlichen luftdicht mit den Längsgurten des oberen Längsträgers zu verbinden, ist es günstig, wenn als weiteres Verbindungselement eine weitere Kederschiene vorgesehen ist, in welcher ein weiteres Kederelement an einem der Längsränder des Dichtfolienstreifens angeordnet ist. Bei dieser Ausführung sind an den gegenüberliegenden Längsrändern jedes Profilelements Kederschienen vorgesehen, welche vorzugsweise im Wesentlichen ident ausgebildet sind. Demnach ist jedes Profilelement nach außen mit einem der Längsränder des Deckfolienelements und nach innen mit einem der Längsränder des Dichtfolienstreifens verbunden.

Gemäß einer alternativen Ausführung der Dichtmittel zwischen dem Konzentrator-Kissen und dem oberen Längsträger ist als Verbindungselement ein Klemmteil zum Festklemmen eines der Längsränder des Deckfolienelements und/oder als weiteres Verbindungselement ein weiteres Klemmteil zum Festklemmen eines der Längsränder des Dichtfolienstreifens vorgesehen. Bei dieser Ausführung sind die Längsränder des Deckfolienelements benachbart der oberen Durchtrittsöffnung für den Längsträger zwischen Sitzflächen des Klemmteils bzw. des Profilelements eingeklemmt. Durch die Klemmung wird das Deckfolienelement im Wesentlichen luftdicht an den Längsträger angeschlossen. Entsprechend kann der Dichtfolienstreifen zwischen den Längsgurten des oberen Längsträgers mittels weiterer Klemmteile an den Längsgurten des oberen Längsträgers im Wesentlichen luftdicht festgeklemmt sein.

Um die Montage Konzentrator-Kissens einfach zu gestalten, ist es vorteilhaft, wenn das Klemmteil zwischen einer den Längsrand des Deckfolienelements freigebenden Stellung und einer den Längsrand des Deckfolienelements festklemmenden Stellung verschwenkbar ist und/oder, dass das weitere Klemmteil zwischen einer den Längsrand des Dichtfolienstreifens freigebenden Stellung und einer den Längsrand des Dichtfolienstreifens festklemmenden Stellung verschwenkbar ist. Bei dieser Ausführung sind die Klemmteile schwenkbar gelagert, so dass das Konzentrator-Kissen durch Verschwenkung der Klemmteile in die Freigabestellung von dem Längsträger entfernt werden kann. Umgekehrt werden die Klemmteile zur luftdichten Verbindung mit dem Längsträger in die Klemmstellung verschwenkt, in welcher die Längsränder des Deckfolienelements fest gegen die Sitzflächen an den Profilelementen auf den Längsgurten der Längsträger festgeklemmt werden. Die Verbindung zwischen den weiteren Klemmteilen und dem Dichtfolienstreifen kann entsprechend hergestellt und gelöst werden.

Gemäß einer weitere Ausführungsform ist als Verbindungselement ein Reißverschlusselement zur Verbindung mit einem entsprechenden Reißverschlusselement an einem der Längsränder des Deckfolienelements und/oder als weiteres Verbindungselement ein weiteres Reißverschlusselement zur Verbindung mit einem entsprechenden weiteren Reißverschlusselement des Dichtfolienstreifens vorgesehen. Bei dieser Ausführung sind die Profilelemente an den Längsgurten mit Reißverschlusselementen versehen, welche insbesondere an schmalen Folienstreifen angebracht sind. Diese Reißverschlusselemente können im Wesentlichen luftdicht mit entsprechenden Reißverschlusselementen verbunden werden, welche an den Längsrändern des Deckfolienelements bzw. des Dichtfolienstreifens angeordnet sind.

Um die Stabilität der Verbindung zwischen dem oberen Längsträger und der Schwenkeinrichtung zu erhöhen, ist es von Vorteil, wenn an den Längsgurten des oberen Längsträgers Halteelemente zur insbesondere formschlüssigen Verbindung mit entsprechenden Halteelementen für die Anbindung der Schwenkeinrichtung vorgesehen sind. Demnach werden die am oberen Längsträger angreifenden Lasten über die Halteelemente an den Längsgurten abgetragen. Vorteilhafterweise wird so eine besonders gute Lastaufnahme erreicht, mit welcher einer Verformung des oberen Längsträgers vorgebeugt wird. Dadurch kann die Aufhängung des Absorbers im Fokusbereich der Reflektorfolie selbst bei widrigen Umweltbedingungen präzise eingehalten werden. Zur Ausbildung der Halteelemente weist das Profilelement bevorzugt in Längsrichtung des Konzentrator-Kissens erstreckte Halteöffnungen auf, in welchen die entsprechenden Halteelemente für die Anbindung der Schwenkeinrichtung aufgenommen sind. Vorzugsweise erstrecken sich die Halteöffnungen an den Profilelementen in Längsrichtung des oberen Längsträgers.

Hinsichtlich einer konstruktiv einfachen, kostengünstigen Ausführung ist es vorteilhaft, wenn die Verstelleinrichtung zur Einstellung des Abstands zwischen dem oberen Längsträger und der Schwenkeinrichtung ein insbesondere im Wesentlichen senkrecht zur Längsrichtung des oberen Längsträgers angeordnetes Verstellelement, insbesondere eine Gewindestange, aufweist. Vorzugsweise ist das eine Ende des Verstellelements mit der Schwenkeinrichtung und das andere Ende des Verstellelements mit einem der Längsgurte des oberen Längsträgers verbunden. Zu diesem Zweck kann die Schwenkeinrichtung ein Winkelelement mit einem im Wesentlichen horizontalen Befestigungsflansch aufweisen, an welchem das eine Ende des Verstellelements angeordnet ist. Bevorzugt ist das Verstellelement als Gewindestange ausgeführt, welche zur Einstellung des Abstands zwischen der Schwenkeinrichtung und dem oberen Längsträger in einer Halteöffnung, insbesondere am oberen Längsträger, verschieblich und in der gewünschten Position mit zumindest einer Gewindemutter fixierbar ist.

Gemäß einer alternativen bevorzugten Ausführung ist zwischen dem oberen Längsträger und der Schwenkeinrichtung zumindest ein Kniehebelelement mit zwei gelenkig miteinander verbundenen Schenkelteilen angeordnet, wobei ein Öffnungswinkel zwischen den Schenkelteilen des Kniehebelelements zur Einstellung des Abstands zwischen der Schwenkeinrichtung und dem oberen Längsträger veränderbar ist. Demnach ist das Kniehebelelement zwischen einem ersten Zustand mit einem geringeren Öffnungswinkel der Schenkelteile, in welchem der oberen Längsträger weiter von der Befestigungsstelle an der Schwenkeinrichtung entfernt ist, und einem zweiten Zustand mit einem größeren Öffnungswinkel der Schenkelteile, in welchem der oberen Längsträger näher an der Befestigungsstelle an der Schwenkeinrichtung angeordnet ist, verschwenkbar angeordnet. Vorzugsweise ist das Kniehebelelement zur im Wesentlichen stufenlosen Verstellung zwischen einem Maximalabstand und einem Minimalabstand zwischen dem oberen Längsträger und der Schwenkeinrichtung eingerichtet. Das Kniehebelelement ist bevorzugt mit einem Feststellelement zum Festlegen des Kniehebelelements mit einem bestimmten Öffnungswinkel verbunden.

Um den Abstand zwischen dem oberen Längsträger und der Schwenkeinrichtung auf einfache Weise anpassen zu können, ist es von Vorteil, wenn das zumindest eine Kniehebelelement zur Veränderung des Öffnungswinkels mit einem Einstellelement gekoppelt ist, welches vorzugsweise im Wesentlichen parallel zur Längsrichtung des oberen Längsträgers angeordnet ist. Vorteilhaft ist dabei, dass die Verstellung mit geringer Bedienkraft vorgenommen werden kann. Vorzugsweise ist bei dieser Ausführung eine Übersetzung zwischen der Verstellung des Einstellelements und der Verschwenkung des Kniehebelelements vorgesehen. Als Einstellelement ist vorzugsweise eine Gewindestange vorgesehen.

Um den oberen Längsträger näher an die Schwenkvorrichtung heranzuführen oder davon weiter zu entfernen, ist es günstig, wenn zwei an den Längsgurten des oberen Längsträgers angeordnete Kniehebelelemente über eine Verbindungsstange miteinander verbunden sind, an welcher vorzugsweise das Einstellelement angreift. Demnach sind Kniehebelelemente an den gegenüberliegenden Längsgurten vorgesehen, wobei zwischen den Kniehebelelementen eine Verbindungsstange erstreckt ist. Dadurch kann die Verstellung der Kniehebelelemente miteinander gekoppelt werden, so dass der Abstand zwischen dem oberen Längsträger und der Schwenkeinrichtung auf beiden Seiten im gleichen Ausmaß veränderbar ist. Für die vorliegende Offenbarung wird der Abstand zwischen dem oberen Längsträger und der Schwenkeinrichtung als kürzeste Entfernung zwischen der Oberseite des oberen Längsträgers und der Unterseite der Schwenkvorrichtung definiert.

Zur Kraftübertragung zwischen dem oberen Längsträger und der Schwenkeinrichtung ist es vorteilhaft, wenn an jedem Längsgurt zwei in Längsrichtung des oberen Längsträgers beabstandete, vorzugsweise über das Einstellelement miteinander gekoppelte Kniehebelelemente befestigt sind.

Um einer unerwünschten Verformung des oberen Längsträgers im laufenden Betrieb ohne Beteiligung des Bedienpersonals vorzubeugen, ist es günstig, wenn die Verstelleinrichtung ein Antriebselement aufweist, mit welchem der Abstand zwischen der Schwenkeinrichtung und dem oberen Längsträger abhängig von einem Lastzustand des oberen Längsträgers selbsttätig nachstellbar ist. Bei dieser Ausführung wird daher der Abstand zwischen der Schwenkeinrichtung und dem oberen Längsträger im laufenden Betrieb automatisch eingestellt, um den oberen Längsträger im Wesentlichen frei von Verformungen zwischen den Befestigungsstellen an der Schwenkeinrichtung zu halten. Zu diesem Zweck ist das Antriebselement zur Erfassung des Lastzustands des oberen Längsträgers eingerichtet, welcher durch die Einspannung des Konzentrator-Kissens an dem oberen Längsträger bewirkt wird, d.h. insbesondere durch die vertikale Kraft aufgrund des Kriechens des Konzentrator-Kissens. Je nach Lastzustand wird der Abstand zwischen der Schwenkeinrichtung und dem oberen Längsträger selbsttätig verändert.

Gemäß einer besonders bevorzugten Ausführung ist als Antriebselement ein Federelement vorgesehen, wobei der Abstand zwischen der Schwenkeinrichtung und dem oberen Längsträger abhängig vom Lastzustand des oberen Längsträgers gegen die Kraft des Federelements einstellbar ist. Durch das Kriechen des Kunststoffmaterials neben der oberen Durchtrittsöffnung des Konzentrator-Kissens wird eine zusätzliche Kraft, insbesondere in vertikaler Richtung, auf den oberen Längsträger ausgeübt, welche eine Kompression des Federelements bewirkt, wobei der obere Längsträger gegen die Federwirkung näher an die Schwenkvorrichtung herangeführt wird. Auf diese Weise wird ein Kräftegleichgewicht herbeigeführt, welches den oberen Längsträger stets im optimalen Abstand zur Schwenkeinrichtung hält, so dass eine Aufbiegung des Längsträgers in dessen Längsrichtung zuverlässig vermieden wird. Dadurch kann der Absorber an der Unterseite des oberen Längsträgers präzise im Fokusbereich der Reflektor- bzw. Spiegelfolie gehalten werden.

Um die Nachführung des Konzentrator-Kissens an den Sonnenlauf, d.h. die momentane Position der Sonne über dem Standort, zu ermöglichen, ist es von Vorteil, wenn die Schwenkvorrichtung zumindest ein das Konzentrator-Kissen in dessen Umfangsrichtung umschließendes Schwenkelement, insbesondere einen Schwenkring, aufweist, wobei der obere Längsträger der Halteeinrichtung mittels der Verstelleinrichtung an dem Schwenkelement aufgehängt ist. Solche Schwenkringe sind im Stand der Technik, vgl. z.B. die WO 2012/145774, an sich bekannt. Der obere Längsträger ist bevorzugt an der Innenseite des Schwenkelements angeordnet, wobei der obere Längsträger mittels der Verstelleinrichtung in der Höhe, d.h. in vertikaler Richtung, verstellbar ist.

Zur Abtragung auf das Konzentrator-Kissen einwirkender Lasten, beispielsweise Windlasten, ist es günstig, wenn mehrere in Längsrichtung des Konzentrator-Kissens beabstandete Schwenkelemente, insbesondere Schwenkringe, vorgesehen sind, an welchen der obere Längsträger der Halteeinrichtung für den Absorber aufgehängt ist, wobei zwischen dem oberen Längsträger und den Schwenkelementen, insbesondere Schwenkringen, jeweils eine Verstelleinrichtung vorgesehen ist. Demnach ist der Längsträger in festgelegten Abständen an Schwenkelementen befestigt, wobei das Konzentrator-Kissen durch die einzelnen Schwenkelemente durchtritt. Vorzugsweise ist der obere Längsträger an jedem Schwenkelement aufgehängt, wobei eine entsprechende Zahl von Verstelleinrichtungen zwischen dem oberen Längsträger und den Schwenkelementen vorgesehen ist. Dadurch können die Abstände zwischen dem oberen Längsträger und den einzelnen Schwenkelementen einzeln eingestellt werden, so dass der obere Längsträger in der gewünschten, insbesondere im Wesentlichen horizontalen, geradlinigen Ausrichtung im Fokusbereich der Spiegelfolie gehalten werden kann.

Um die am Konzentrator-Kissen angreifenden Lasten aufzunehmen und somit unerwünschte Verformungen des Konzentrator-Kissens im Betrieb möglichst zu verhindern, ist es günstig, wenn ein unterer Längsträger der Halteeinrichtung an einer im Wesentlichen luftdicht verschlossenen unteren Durchtrittsöffnung des Konzentrator-Kissens angeordnet ist, wobei zwischen dem unteren Längsträger der Halteeinrichtung und der Schwenkeinrichtung eine weitere Verstelleinrichtung zur Einstellung des Abstands zwischen dem unteren Längsträger und der Schwenkeinrichtung vorgesehen ist. Demnach ist das Konzentrator-Kissen bei dieser Ausführung an zumindest zwei, vorzugsweise genau zwei, Längsträgern angebracht. Bei dieser Ausführung ist zudem eine weitere Verstelleinrichtung zur Einstellung des Abstands zwischen dem unteren Längsträger und der Schwenkeinrichtung vorgesehen, welche ident wie die Verstelleinrichtung zwischen dem oberen Längsträger und der Schwenkeinrichtung ausgebildet sein kann. Demnach können sich die vorstehend beschriebenen bevorzugten Ausführungen der Verstelleinrichtung entsprechend auf die weitere Verstelleinrichtung zwischen dem unteren Längsträger und der Schwenkeinrichtung beziehen.

Bei dieser Ausführung ist es insbesondere günstig, wenn die untere Durchtrittsöffnung an einem an den unteren Hohlraum grenzenden Bodenfolienelement des Konzentrator-Kissens vorgesehen ist. Vorteilhafterweise wird das Konzentrator-Kissen daher an dessen Oberseite und an dessen Unterseite fixiert, wohingegen die Längsseiten des Konzentrator-Kissens, insbesondere im Bereich der Längsränder der Reflektorfolie, in radialer Richtung ausdehnbar angeordnet sind. Dadurch kann eine thermische Ausdehnung des Konzentrator-Kissens insbesondere im Bereich der Reflektorfolie freigegeben werden, wodurch die konkave Geometrie der Reflektorfolie für die Bündelung der Sonnenstrahlung im Absorber präzise eingehalten wird.

Zur Anbringung des Konzentrator-Kissens an der Halteeinrichtung ist es insbesondere günstig, wenn der mit dem Deckfolienelement verbundene obere Längsträger und der mit dem Bodenfolienelement des Konzentrator-Kissens verbundene untere Längsträger im Wesentlichen ident ausgebildet sind. Bevorzugt sind der obere Längsträger und der untere Längsträger in der Art von Fachwerkträgern ausgebildet, wobei der obere Längsträger durch die Durchtrittsöffnung an dem Deckfolienelement und der untere Längsträger durch die untere Durchtrittsöffnung an dem Bodenfolienelement durchtritt.

Um die Geometrie des Konzentrator-Kissens und die Anordnung des Absorbers auch bei hohen äußeren Lasten zu gewährleisten, ist der obere Längsträger und/oder der untere Längsträger vorzugsweise zumindest über mehr als die Hälfte der Länge des Konzentrator-Kissens erstreckt, wobei sich der obere Längsträger und/oder der untere Längsträger bevorzugt zwischen einem vorderen Endstück und einem hinteren Endstück an den Stirnseiten des Konzentrator-Kissens erstreckt. Besonders günstig ist es daher, wenn sich der obere Längsträger und der untere Längsträger über im Wesentlichen die gesamte Länge des Konzentrator-Kissens erstrecken. Bei dieser Ausführung enden die Längsträger bevorzugt benachbart der Endstücke des Konzentrator-Kissens, mit welchen der obere und untere Hohlraum des Konzentrator-Kissens im Wesentlichen luftdicht verschlossen werden.

Zur Verankerung der Schwenkeinrichtung an einer Bodenstruktur ist insbesondere eine Verankerungseinrichtung vorgesehen, welche vorzugsweise eine Aufhängeeinrichtung zum Aufhängen der Schwenkeinrichtung aufweist. Beim Stand der Technik der WO 2012/145774 ist zur Verankerung des Konzentrators ein Verankerungsgerüst vorgesehen. Das Verankerungsgerüst weist ein Nachführungssystem auf, um den kissenförmigen Konzentrator dem Sonnenlauf nachzuführen. Das Nachführungssystem besteht aus mehreren das Konzentrator-Kissen umschließenden Nachführungsringen, welche mittels Rollvorrichtungen drehbar gelagert sind. Die Nachführungsringe sind auf bodenseitigen Sockelelementen abgestützt. Bei Testversuchen hat sich jedoch gezeigt, dass die am Boden abgestützen Nachführungsringe im Betrieb hohen Kippmomenten, insbesondere aufgrund von Windlasten, ausgesetzt sind. Um den Belastungen im Betrieb standzuhalten, mussten daher die Nachführungsringe vergleichsweise massiv ausgebildet werden. Dennoch konnte bei der bisherigen Ausführung die äußeren Lasten nicht vollständig von dem schlauchförmigen Konzentrator und dem Verankerungsgerüst ferngehalten werden. Infolge der äußeren Einflüsse wurden im Betrieb Verformungszustände des Konzentrators beobachtet. Solche Verformungen könnten jedoch die Lebensdauer des Konzentrators verkürzen bzw. Beschädigungen hervorrufen. Noch wesentlicher ist jedoch, dass die Einflüsse auf die Geometrie der gekrümmten Reflektorfolie den Wirkungsgrad des Konzentrators senken können. Weiters wurde die Aufhängung für den Absorber nicht immer vollständig im Fokusbereich der Reflektorfolie gehalten. Dies wirkt sich ebenfalls nachteilig auf den Wirkungsgrad des Konzentrators auf. Um die Aufnahme äußerer Lasten, insbesondere Windlasten, zu verbessern, ist es günstig, wenn die Verankerungseinrichtung eine Aufhängeeinrichtung zum Aufhängen der Schwenkeinrichtung auf. Im Unterschied zum Stand der Technik wird daher die Schwenk- und Halteeinrichtung für das Konzentrator-Kissen nicht mehr am Boden von der Unterseite her abgestützt, sondern oberseitig an einer Aufhängeeinrichtung aufgehängt. Demnach wird die Schwenkeinrichtung, an welcher im Betriebszustand das Konzentrator-Kissen befestigt ist, im Wesentlichen vollständig durch die Aufhängeeinrichtung getragen. Die Schwenkeinrichtung ist zum Verschwenken des Konzentrator-Kissens, vorzugsweise um dessen Längsachse, eingerichtet. Für die Zwecke dieser Offenbarung bedeutet die Aufhängung der Schwenkeinrichtung, dass die Befestigungsstellen zwischen der Aufhängeeinrichtung und der Schwenkeinrichtung ausschließlich oberhalb einer den Massenmittelpunkt der Schwenkeinrichtung aufweisenden Ebene angeordnet sind. Die Begriffe "oben" und "unten" beziehen sich hierbei auf die Betriebsstellung der Vorrichtung. Diese Ausführung hat insbesondere den Vorteil, dass die äußeren Lasten, wie Windkräfte, besonders effizient aufgefangen und an ein Fundament am Standort abgeleitet werden können. Vorteilhaft ist insbesondere, dass der kissen- bzw. schlauchförmige Konzentrator weitgehend frei von äußeren Einflüssen gehalten wird. Dadurch kann die konkave Wölbung der Reflektorfolie zwischen dem oberen und dem unteren Druckraum des Konzentrators präzise eingehalten werden, so dass die Fokussierung der Sonnenstrahlung am Absorber mit hohem Wirkungsgrad erfolgt. Weiters ist die erfindungsgemäße Ausgestaltung dahingehend vorteilhaft, dass die Schwenkeinrichtung schlanker als beim Stand der Technik ausgeführt werden kann. Somit können Materialkosten eingespart werden. Weiters wird der Verschattungsgrad der Reflektorfolie verringert, wodurch der Wirkungsgrad weiter gesteigert werden kann.

Zum Aufhängen der Schwenkeinrichtung für das Konzentrator-Kissen ist es günstig, wenn die Aufhängeeinrichtung zumindest einen Trägerrahmen, vorzugsweise mehrere in Längsrichtung des Konzentrator-Kissens beabstandet angeordnete Trägerrahmen, aufweist, wobei der zumindest eine Trägerrahmen jeweils zumindest ein erstes Rahmenelement auf der einen Längsseite des Konzentrator-Kissens und ein zweites Rahmenelement auf der anderen Längsseite des Konzentrator-Kissens aufweist. Vorteilhafterweise kann der Trägerrahmen sehr gut aus Standardprofilen hergestellt werden, was schon bei geringen Stückzahlen zu erheblichen Kostenvorteilen führt.

Um die Stabilität der Aufhängeeinrichtung zu erhöhen, ist es von Vorteil, wenn der Trägerrahmen ein drittes Rahmenelement oberhalb des Konzentrator-Kissens aufweist, welches das erste Rahmenelement auf der einen Längsseite des Konzentrator-Kissens mit dem zweiten Rahmenelement auf der anderen Längsseite des Konzentrator-Kissens verbindet. Bei dieser Ausführung erstreckt sich der Trägerrahmen daher von der einen Längsseite des Konzentrator-Kissens über die Oberseite des Konzentrator-Kissens hinweg auf die andere Längsseite des Konzentrator-Kissens, so dass das Konzentrator-Kissen im montierten Betriebszustand vollständig innerhalb des Trägerrahmens angeordnet ist. Die Schwenkeinrichtung ist bevorzugt an der Unterseite des Trägerrahmens aufgehängt. Demnach wird die Schwenkeinrichtung vorzugsweise im Wesentlichen vollständig von dem Trägerrahmen eingerahmt. Diese Ausführung hat sich als besonders günstig erwiesen, um die im Betrieb auftretenden Kräfte, beispielsweise Windkräfte, aufzunehmen.

Zur Nachführung des Konzentrator-Kissens an den Sonnenlauf ist es vorteilhaft, wenn zwischen der Aufhängeeinrichtung und der Schwenkeinrichtung eine Schwenklagereinrichtung, insbesondere eine Rollenlagerung, vorgesehen ist. Solche Rollenlagerungen sind im Stand der Technik, vgl. z.B. die WO 2012/145774, an sich bekannt. Die Rollenlagerung weist Rollenelemente auf, welche insbesondere an einer Laufkatze vorgesehen sind. Die Rollenelemente sind mit einem Antrieb verbunden, wobei die Rollenelemente im angetriebenen Zustand durch einen Reibschluss beim Abrollen auf der Schwenkeinrichtung ein Drehmoment erzeugen, welches eine Verschwenkung der Schwenkeinrichtung mit dem Konzentrator-Kissen um eine Achse, insbesondere um die Längsachse des Konzentrator-Kissens, bewirkt.

Die Erfindung wird nachstehend anhand von in der Zeichnung dargestellten Ausführungsbeispielen, auf die sie jedoch nicht beschränkt sein soll, noch weiter erläutert. In der Zeichnung zeigt:
Fig. 1a eine schaubildliche Ansicht einer erfindungsgemäßen Vorrichtung zur Konzentration von Sonnenstrahlung in einem Absorber (vgl. Fig. 2), bei welcher mehrere Schwenkringe zum Verschwenken eines Konzentrator-Kissens (vgl. Fig. 1b, 1c und Fig. 2) an einem Trägerrahmen aufgehängt sind;
Fig. 1b eine weitere schaubildliche Ansicht der erfindungsgemäßen Vorrichtung gemäß Fig. 1a, wobei zusätzlich das Konzentrator-Kissen (ohne dessen Endstücke) ersichtlich ist;
Fig. 1c eine weitere schaubildliche Ansicht der erfindungsgemäßen Vorrichtung gemäß Fig. 1b, wobei das Konzentrator-Kissen im Betriebszustand einschließlich dessen Endstücke ersichtlich ist;
Fig. 2 eine Querschnittsansicht der Vorrichtung gemäß Fig. 1, wobei das Konzentrator-Kissen im montierten Zustand ersichtlich ist;
Fig. 3 eine schaubildliche Detailansicht eines Ausschnitts der Vorrichtung gemäß Fig. 1, 2, wobei die Befestigung eines das Konzentrator-Kissen tragenden oberen Längsträgers am Schwenkring ersichtlich ist;

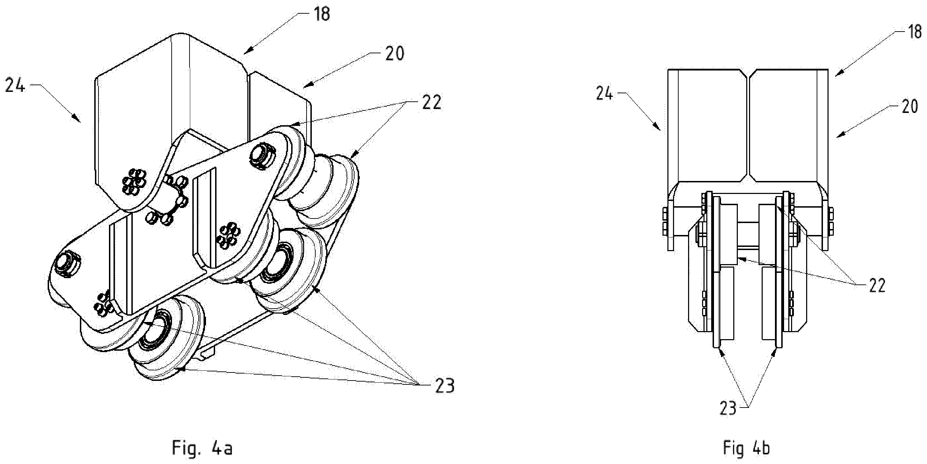

Fig. 4a und Fig. 4b je eine schaubildliche Ansicht einer Schwenklagereinrichtung zum Verschwenken der Schwenkeinrichtung;
Fig. 5 eine schaubildliche Detailansicht eines Ausschnitts der Vorrichtung gemäß Fig. 1 bis 3, wobei die Befestigung des Konzentrator-Kissens an dem oberen Längsträger ersichtlich ist;
Fig. 6a das in Fig. 5 mit einem Kreis veranschaulichte Detail A;
Fig. 6b eine Fig. 6a entsprechende Detailansicht mit einer alternativen Ausführung des oberen Längsträgers;
Fig. 7a und Fig. 7b jeweils einen Ausschnitt einer alternativen erfindungsgemäßen Ausführung der Vorrichtung, bei welcher ein luftdichter Reißverschluss zur Anbindung des Konzentrator-Kissens an den oberen Längsträger vorgesehen ist;
Fig. 8a und Fig. 8b jeweils einen Ausschnitt einer weiteren alternativen erfindungsgemäßen Ausführung der Vorrichtung, bei welcher die Längsränder des Konzentrator-Kissens an den oberen Längsgurten des Längsträgers festklemmbar sind, wobei in Fig. 8a die Freigabestellung und in Fig. 8b die Klemmstellung dargestellt ist;
Fig. 9 eine vergrößerte schaubildliche Ansicht eines der Schwenkringe der Konzentrator-Vorrichtung gemäß Fig. 1 bis 3, wobei die Längsträger in der Höhe verstellbar an dem Schwenkring montiert sind;
Fig. 10a eine vergrößerte Darstellung des in Fig. 9 mit einem Kreis veranschaulichten Details B, wobei die Verstelleinrichtung mittels einer Gewindestange auf einen größeren Abstand zwischen dem oberen Längsträger und dem Schwenkring eingestellt ist;
Fig. 10b eine Detailansicht entsprechend Fig. 10a, wobei der Längsträger durch Verstellung der Gewindestange näher an den Schwenkring herangeführt wurde;
Fig. 11a bis 11d Detailansichten einer alternativen Ausführung der Verstelleinrichtung, bei welcher Kniehebelelemente zwischen dem Schwenkring und dem oberen Längsträger zur Abstandsjustierung vorgesehen sind, wobei die Kniehebelelemente in Fig. 11a, 11c auf einen größeren Abstand zwischen dem Schwenkring und dem oberen Längsträger als in Fig. 11b, 11d eingestellt sind; und
Fig. 12a bis 12d Detailansichten einer alternativen Ausführung der Verstelleinrichtung, bei welcher die Kniehebelelemente gegen die Kraft eines Federelements selbständig auf den passenden Abstand zwischen dem Schwenkring und dem oberen Längsträger nachführbar sind, wobei die Kniehebelelemente in Fig. 12a, 12c auf einen größeren Abstand zwischen dem Schwenkring und dem oberen Längsträger als in Fig. 12b, 12d eingestellt sind.

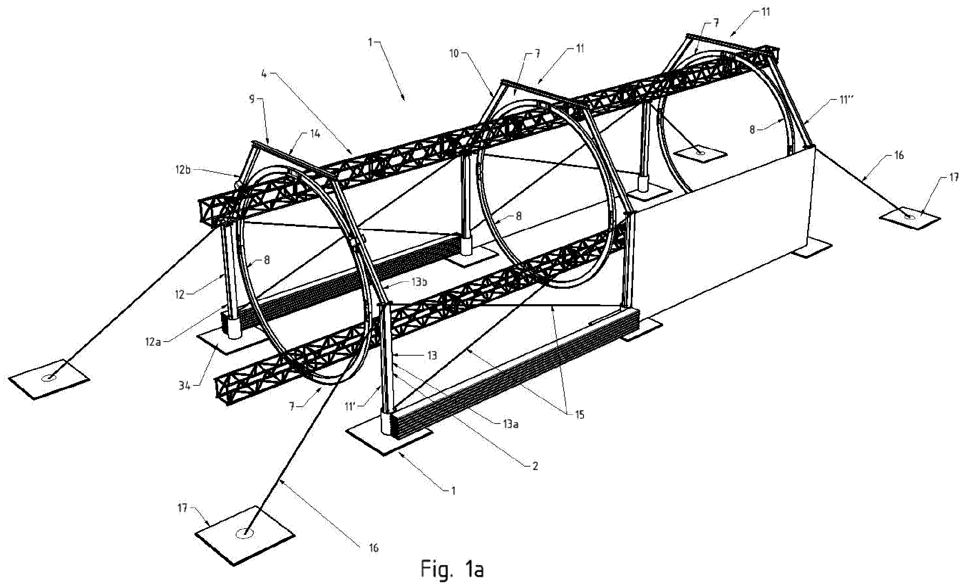

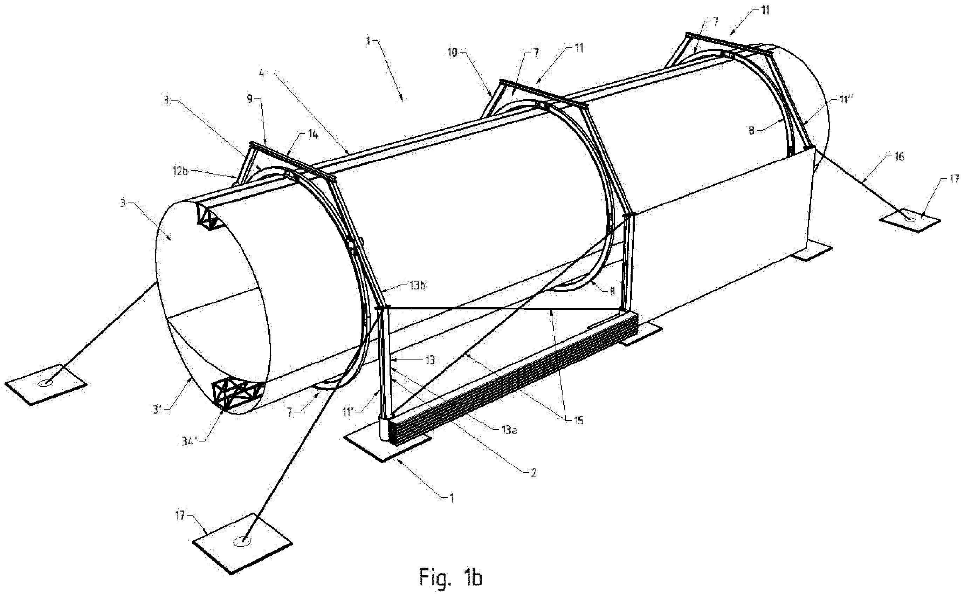

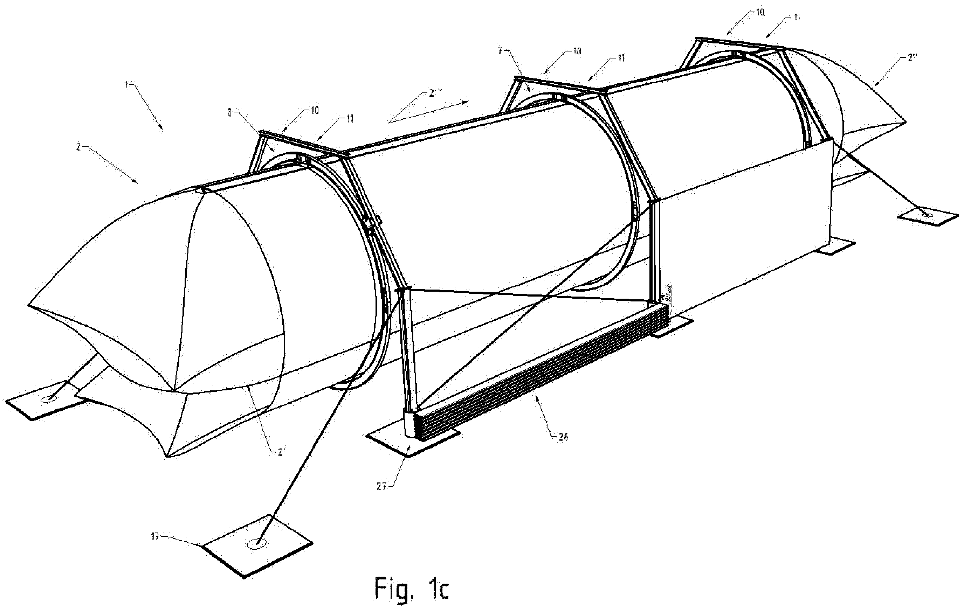

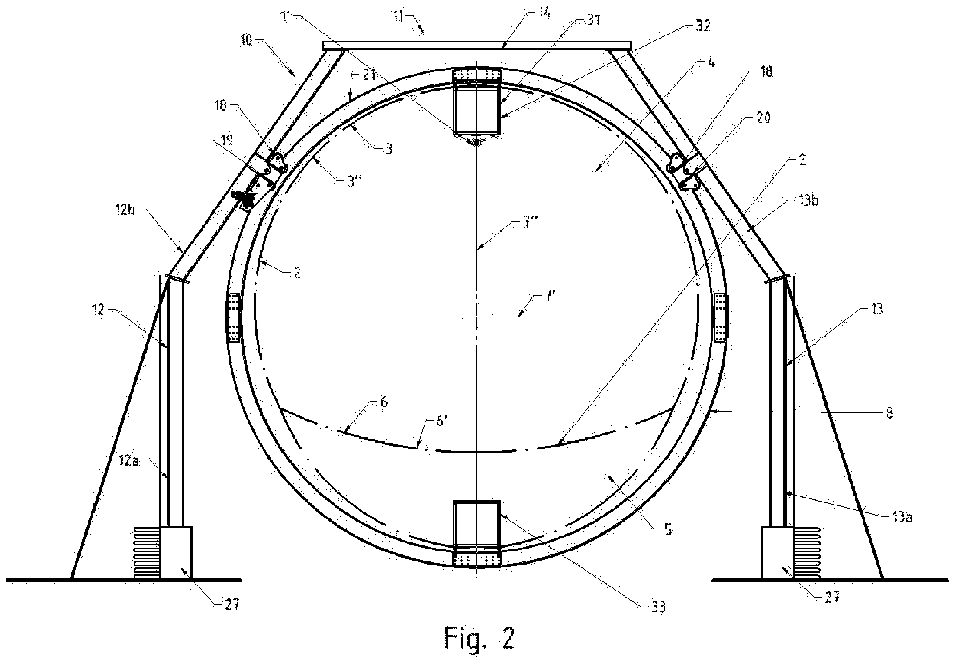

In Fig. 1 ist eine Vorrichtung 1 zur Konzentration von Sonnenstrahlung in einem Absorber 1' (vgl. Fig. 2) gezeigt. Die Vorrichtung 1 weist ein aufblasbares Konzentrator-Kissen 2 (vgl. Fig. 1b, 1c und Fig. 2) auf. Das Konzentrator-Kissen 2 weist ein Deckfolienelement 3" mit einem lichtdurchlässigen Eintrittsfenster 3 zum Einkoppeln von Sonnenstrahlung und eine das Konzentrator-Kissen 2 in zumindest zwei Hohlräume 4, 5 unterteilende, im Betriebszustand gekrümmte Reflektorfolie 6 zum Konzentrieren der Sonnenstrahlung in einem Absorber 1' auf. Die Reflektorfolie 6 weist eine Spiegelfläche 6' auf, welche die eingekoppelte Sonnenstrahlung in Richtung des Absorbers 1' bündelt. Der Absorber 1', worunter auch ein Solarpaneel zu verstehen ist, befindet sich im Fokusbereich der Spiegelfläche 6' innerhalb des oberen, an das Eintrittsfenster 3 anschließenden Hohlraums 4 des Konzentrator-Kissens 2. Als Absorber 1' kann insbesondere ein mediendurchströmtes Rohr oder ein Photovoltaikelement vorgesehen sein. Der Konzentrator kann somit sowohl für konzentrierte Photovoltaik (CPV = Concentrated Photovoltaics) als auch für konzentrierte Solarthermie (CSP = Thermal Concentrated Solar Power) verwendet werden. Im Betrieb des Konzentrators wird in den luftbefüllten Hohlräumen 4, 5 ein Druckunterschied ausgebildet, wodurch die Reflektorfolie 6 gleichmässig konkav gewölbt wird, so dass die eingekoppelte Sonnenstrahlung von der Spiegelfläche 6' in den Absorber 1' fokussiert wird. Das Konzentrator-Kissen 2 ist in dem mit Druckluft in den Hohlräumen 4, 5 befüllten Zustand grundsätzlich selbsttragend ausgelegt, so dass gegenüber herkömmlichen Solarkonzentratoren ein erheblich niedrigeres Gewicht realisierbar ist. Wie im Stand der Technik bekannt, ist das Konzentrator-Kissen 2 aus einzelnen dünnwandigen (Kunststoff-)Folien aufgebaut; für das Eintrittsfenster 3 ist eine transparente Folie vorgesehen.

Wie aus Fig. 1 weiters ersichtlich, ist eine Schwenkeinrichtung 7 zum Verschwenken des Konzentrator-Kissens 2 vorgesehen. Die Schwenkeinrichtung 7 weist mehrere Schwenkelemente in Form von Schwenkringen 8 auf, welche das Konzentrator-Kissen 2 in Umfangsrichtung umschließen. Die Schwenkringe 8 der Schwenkeinrichtung 7 bilden zusammen ein Nachführungssystem, um das Konzentrator-Kissen 2 im Betrieb dem Sonnenlauf nachzuführen. Hierfür ist die Schwenkeinrichtung 7 dazu eingerichtet, das Konzentrator-Kissen 2 um zumindest eine Achse des Konzentrator-Kissens 2, hier speziell die Längsachse des Konzentrator-Kissens 2, schwenkbar zu lagern.

Wie aus Fig. 1, 2 weiters ersichtlich, ist zudem eine Verankerungseinrichtung 9 für die Schwenkeinrichtung 7 vorgesehen, wobei die Verankerungseinrichtung 9 in der gezeigten Ausführung eine Aufhängeeinrichtung 10 zum Aufhängen der Schwenkringe 8 der Schwenkeinrichtung 7 aufweist. Die Aufhängeeinrichtung 10 weist mehrere in Längsrichtung des Konzentrator-Kissens 2 beabstandet angeordnete Trägerrahmen 11 auf, welche Befestigungsstellen für die Schwenkringe 8 der Schwenkeinrichtung 7 aufweisen. Die Befestigungsstellen sind oberhalb einer den Massenmittelpunkt aufweisenden Ebene 7' (vgl. Fig. 2) der Schwenkringe 8 angeordnet. Jeder Trägerrahmen 11 weist ein erstes Rahmenelement 12 auf der einen Längsseite des Konzentrator-Kissens 2 und ein zweites Rahmenelement 13 auf der anderen Längsseite des Konzentrator-Kissens 2 auf. Darüber hinaus weist der Trägerrahmen 11 ein drittes Rahmenelement 14 oberhalb der Schwenkeinrichtung 7 mit dem Konzentrator-Kissen 2 auf. Das erste Rahmenelement 12 auf der einen Längsseite des Konzentrator-Kissens 2 ist über das dritte Rahmenelement 14 mit dem zweiten Rahmenelement 13 auf der anderen Längsseite des Konzentrator-Kissens 2 verbunden. Demnach erstreckt sich der Trägerrahmen 11 bogenförmig von der einen Längsseite des Konzentrator-Kissens 2 über das Konzentrator-Kissen 2 hinweg auf die andere Längsseite des Konzentrator-Kissens 2.

Wie aus Fig. 1, 2 weiters ersichtlich, bestehen das erste Rahmenelement 12 und das zweite Rahmenelement 13 jeweils aus einem ersten geraden bzw. linearen Rahmenteil 12a, 13a und einem zweiten geraden bzw. linearen Rahmenteil 12b, 13b. Das erste Rahmenteil 12a, 13a ist im Betriebszustand im Wesentlichen senkrecht angeordnet, wobei das untere Ende des ersten Rahmenteils 12a, 13a in einem Sockelelement 27 montiert ist. Das zweite Rahmenteil 12b, 13b ist vom oberen Ende des ersten Rahmenteils 12a, 13a nach innen, zum Konzentrator-Kissen 2 hin abgewinkelt.

Wie aus Fig. 1, 2 weiters ersichtlich, sind das erste Rahmenelement 12, das zweite Rahmenelement 13 und das dritte Rahmenelement 14 als langestreckte Profilelemente ausgebildet, welche in der gezeigten Ausführungsform einen I-förmigen Querschnitt aufweisen. Die Rahmenelemente 12, 13, 14 sind in einer Ebene im Wesentlichen senkrecht zur Längsrichtung des Konzentrator-Kissens 2 angeordnet.

Wie aus Fig. 1 weiters ersichtlich, weist die Aufhängeeinrichtung 10 mehrere, in der gezeigten Ausführung drei, Trägerrahmen 11 auf, welche über mehrere Spannelemente 15 in Form von Seilelementen miteinander verbunden. Die Anzahl der Trägerrahmen 11 hängt von der Länge des Konzentrator-Kissens 2 ab. Die Trägerrahmen 11 tragen jeweils einen Schwenkring 8, welcher das Konzentrator-Kissen 2 umgibt. In der gezeigten Ausführung sind einerseits die ersten Rahmenelemente 12 der Trägerrahmen 11 auf der einen Längsseite des Konzentrator-Kissens 2 über Spannelemente 15 miteinander verspannt, andererseits sind Spannelemente 15 zwischen den zweiten Rahmenelementen 13 der Trägerrahmen 11 auf der anderen Längsseite des Konzentrator-Kissens 2 vorgesehen. Auf beiden Längsseiten sind in der gezeigten Ausführung zwei Spannelemente 15 zwischen den Trägerrahmen 11 über Kreuz gespannt. Der vordere Trägerrahmen 11' und der hintere Trägerrahmen 11", jeweils bezogen auf die Längsrichtung des Konzentrator-Kissens 2, sind über weitere Spannelemente 16 auf beiden Längsseiten des Konzentrator-Kissens 2 an Bodenelementen 17 abgespannt. In der gezeigten Ausführung sind die weiteren Spannelemente 16 durch Endbereiche von Spannelementen 15 zwischen den Trägerrahmen 11 gebildet.

Wie aus Fig. 2 ersichtlich, sind zwischen der Aufhängeeinrichtung 10 und den Schwenkringen 8 der Schwenkeinrichtung 7 Schwenklagereinrichtungen 18 in Form von Rollenlagerungen 19, 20 vorgesehen. In der gezeigten Ausführung ist eine erste Rollenlagerung 19 an dem ersten Rahmenelement 12 der Aufhängeeinrichtung 10 und eine zweite Rollenlagerung 20 an dem zweiten Rahmenelement 13 der Aufhängeeinrichtung 10 vorgesehen.

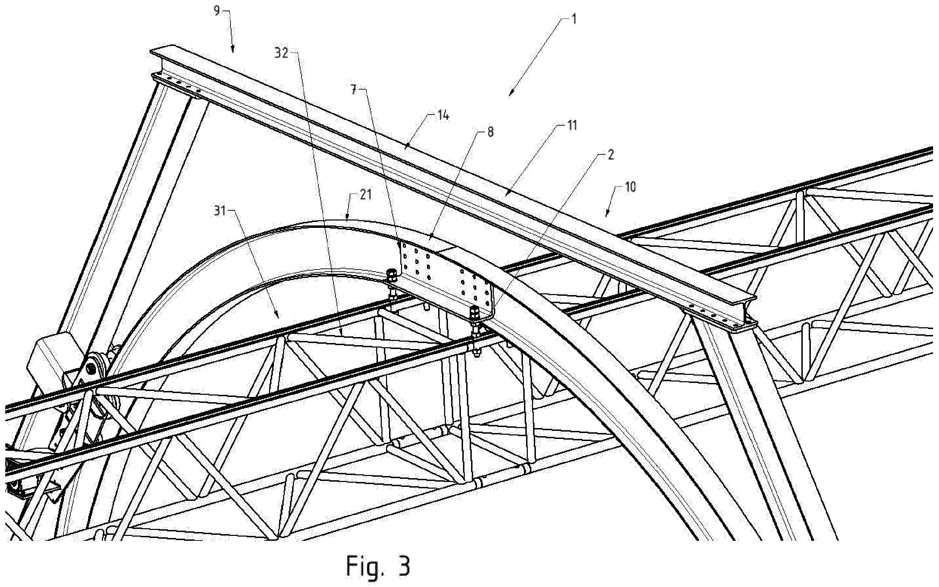

Wie aus Fig. 3 ersichtlich, weisen die Schwenkringe 8 jeweils ein Führungselement 21 für die Rollenlagerungen 19, 20 auf, wobei äußere Rollenelemente 22 auf der Oberseite des Führungselements 21 und innere Rollenelemente 23 auf der Innenseite des Führungselements 21 abrollen. Die Rollenelemente 22, 23 der Rollenlagerungen 19, 20 sind an Laufkatzen 24 montiert, welche an der Unterseite des Schwenkrings 8 befestigt sind. In der gezeigten Ausführung weisen die Schwenkringe 8 jeweils einen I-förmigen Querschnitt auf, wobei obere Flansche 25 der I-förmigen Schwenkringe 8 als Führungselemente 21 für die Rollenlagerungen 19, 20 ausgebildet sind.

Wie aus Fig. 1b ersichtlich, ist an der Aufhängeeinrichtung 10 eine Abdeckeinrichtung 26 vorgesehen, welche zwischen einer das Konzentrator-Kissen 2 zumindest teilweise abdeckenden Schutzstellung und einer das Konzentrator-Kissen 2 im Wesentlichen vollständig freiliegend anordnenden Staustellung überführbar ist. In der gezeigten Ausführung sind mehrere Abdeckeinrichtungen 26 jeweils zwischen zwei benachbarten Trägerrahmen 11 an den ersten Rahmenelementen 12 auf der einen Längsseite des Konzentrator-Kissens 2 bzw. an den ersten Rahmenelementen 13 auf der anderen Längsseite des Konzentrator-Kissens 2 befestigt. Die Abdeckeinrichtungen 26 bestehen in der gezeigten Ausführung aus mehreren miteinander verbundenen Lamellenelementen, welche zwischen einer zusammengeschobenen Stellung und einer auseinandergezogenen Stellung überführbar sind. In der Darstellung der Fig. 1b sind die beiden vorderen Abdeckeinrichtungen 26 in der zusammengeschobenen Stellung angeordnet, in welcher Windkräfte an der unteren Hälfte des Konzentrator-Kissens 2 angreifen können. Die beiden hinteren Abdeckeinrichtungen 26 sind hingegen in der auseinandergezogenen Stellung angeordnet, in welcher Windkräfte vom unteren Bereich des Konzentrator-Kissens 2 ferngehalten werden können. Die Abdeckeinrichtungen 26 können motorisch oder manuell zwischen der Staustellung und der Schutzstellung überführt werden.

Wie aus Fig. 1, 3 ersichtlich, weist die Vorrichtung 1 zudem eine Halteeinrichtung 31 für das Konzentrator-Kissen 2 auf, welche (jeweils bezogen auf die Betriebsstellung) einen oberen Längsträger 32 und einen unteren Längsträger 33 aufweist. Der obere Längsträger 32 trägt den Absorber 1' (vgl. Fig. 2), wohingegen der untere Längsträger 33 zur Ableitung von äußeren Lasten beiträgt. Beide Längsträger 32, 33 erstrecken sich in Längsrichtung des Konzentrator-Kissens 2 zwischen einem vorderen Endstück 2' und einem hinteren Endstück 2" an den Stirnseiten des Konzentrator-Kissens 2 (vgl. Fig. 1c).

Wie aus der Zeichnung weiters ersichtlich, ist der obere Längsträger 32 innenseitig am oberen Bereich der Schwenkringe 8 aufgehängt. Der untere Längsträger 33 ist ebenfalls innenseitig, aber im unteren Bereich der Schwenkringe 8 angebracht. Der obere Längsträger 32 ist mit einer der Sonnenstrahlung zugewandten Oberseite des Konzentrator-Kissens 2 verbunden. Der untere Längsträger 33 ist mit einer von der Sonnenstrahlung abgewandten Unterseite des Konzentrator-Kissens 2 verbunden. Die Längsträger 32, 33 sind in der gezeigten Ausführung als Fachwerkträger ausgeführt. Wie aus Fig. 2 ersichtlich, sind die Längsträger an einer den Mittelpunkt des Schwenkrings 8 aufweisenden Ebene 7" angeordnet.

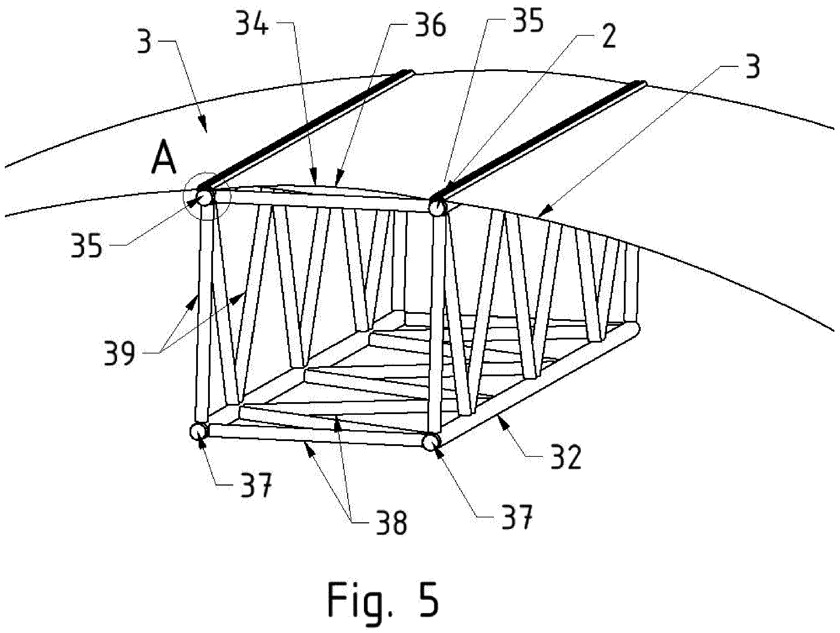

Wie aus Fig. 5 ersichtlich, ist der obere Längsträger 32 an einer oberen Durchtrittsöffnung 34 des Konzentrator-Kissens 2 angeordnet, welche nach allen Seiten hin im Wesentlichen luftdicht verschlossen ist. Zu diesem Zweck weist der obere Längsträger 32 zwei in Längsrichtung des Konzentrator-Kissens 2 (d.h. in Richtung dessen längerer Erstreckung) verlaufende Längsgurte 35 auf, welche jeweils im Wesentlichen luftdicht mit Längsrändern des Konzentrator-Kissens 2 beidseits der oberen Durchtrittsöffnung 34 des Deckfolienelements 3" verbunden sind. Der obere Längsträger 32 weist daher im Wesentlichen dieselbe Breite wie die Durchtrittsöffnung 34 des Konzentrator-Kissens 2 auf, welche sich in Längsrichtung des Konzentrator-Kissens 2 im Wesentlichen über dessen gesamte Länge erstreckt. Um einen Luftaustritt aus dem oberen Hohlraum 4 des Konzentrator-Kissens zu verhindern, ist zwischen den Längsgurten 35 ein Dichtfolienstreifen 36 angeordnet, mit welchem die obere Durchtrittsöffnung 34 des Konzentrator-Kissens 2 verschlossen wird. Der Dichtfolienstreifen 36 ist aus einem transparenten Kunststoffmaterial, insbesondere aus Ethylen-Tetrafluorethylen (ETFE), gefertigt.

Der untere Längsträger 33 ist an einer im Wesentlichen luftdicht verschlossenen unteren Durchtrittsöffnung 34' des Konzentrator-Kissens 2 angeordnet (vgl. Fig. 1b), wobei sich die untere Durchtrittsöffnung 34' an einem an den unteren Hohlraum 5 grenzenden Bodenfolienelement 3' des Konzentrator-Kissens 2 erstreckt. Die obere 34 und die untere Durchtrittsöffnungen 34' weisen dieselbe Längserstreckung wie der obere Längsträger 32 bzw. der untere Längsträger 33 auf. Der untere Längsträger 33 ist dabei im Wesentlichen ident wie der obere Längsträger 32 ausgebildet. Darüber hinaus ist die Verbindung zwischen dem unteren Längsträger 33 und dem Bodenfolienelement 3' entsprechend der Verbindung zwischen dem oberen Längsträger 33 und dem Deckfolienelement 3" gestaltet. Die nachstehenden Ausführungen zum oberen Längsträger 32 sind daher entsprechend für den unteren Längsträger 33 zu verstehen.

Wie aus Fig. 5 weiters ersichtlich, weist der obere Längsträger 32 zwei weitere Längsgurte 37 auf, welche parallel zu den Längsgurten 35 in Längsrichtung des Konzentrator-Kissens 2 erstreckt sind. Die weiteren Längsgurte 37 des oberen Längsträgers 32 sind innerhalb des oberen Hohlraums des Konzentrator-Kissens 2 angeordnet. Die Längsgurte 35 und die weiteren Längsgurte 37 des oberen Längsträgers 32 sind unter Ausbildung von Zwischenräumen über Füllstäbe 38 miteinander verbunden. Weitere Füllstäbe 39 sind zwischen den Längsgurten 35 und den weiteren Längsgurten 37 vorgesehen sind.

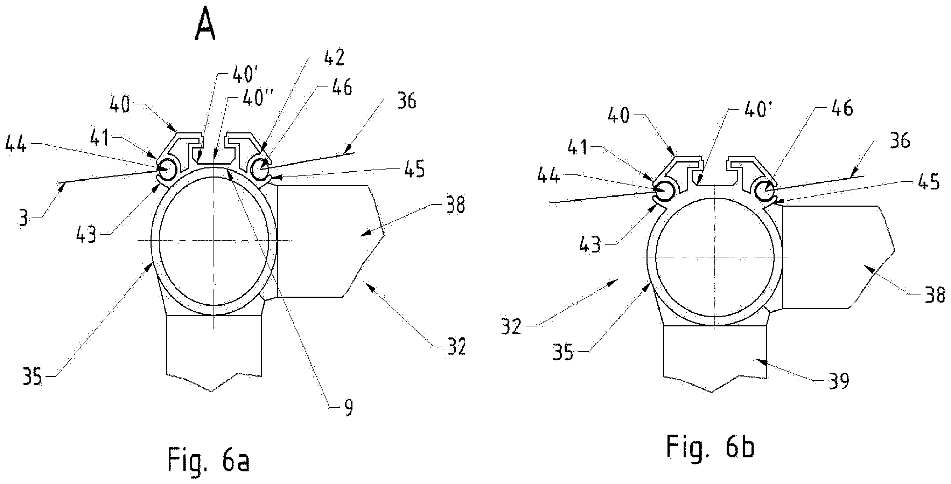

Wie aus Fig. 6 im Detail ersichtlich, sind an den Längsgurten 35 des oberen Längsträgers 32 Profilelemente 40 angeordnet. Jedes Profilelement 40 ist auf der einen Seite mit einem Verbindungselement 41 zur im Wesentlichen luftdichten Verbindung mit dem benachbarten Längsrand des Deckfolienelements 3" und auf der anderen Seite mit einem weiteren Verbindungselement 42 zur im Wesentlichen luftdichten Verbindung mit dem benachbarten Längsrand des Dichtfolienstreifens 36 verbunden. In Fig. 6b ist eine Ausführung gezeigt, bei welcher das Profilelement 40 als eigenes Bauteil auf der Oberseite des Längsgurtes 35 angebracht ist. Gemäß Fig. 6b ist das Profilelement 40 einteilig mit dem Längsgurt 35 des oberen Längsträgers 32 gebildet.

Wie aus Fig. 6 ersichtlich, sind bei dieser Ausführung an den Längsgurten 35 des oberen Längsträgers 32 Halteelemente 40' zur formschlüssigen Verbindung mit entsprechenden Halteelementen (nicht gezeigt) an der Schwenkeinrichtung 7 vorgesehen, um den oberen Längsträger 32 an der Schwenkeinrichtung 7 aufzuhängen. In der gezeigten Ausführung weist das Profilelement 40 zur Ausbildung der Halteelemente 40' in Längsrichtung des Konzentrator-Kissens 2 erstreckte Halteöffnungen 40" auf, in welchen die entsprechenden Halteelemente für die Anbindung der Schwenkeinrichtung aufgenommen sind.

In den Ausführungsvarianten der Fig. 5, 6 ist als Verbindungselement 41 eine Kederschiene 43 vorgesehen, in welcher ein Kederelement 44 am zugehörigen Längsrand des Deckfolienelements 3" dichtend aufgenommen ist. Entsprechend ist als weiteres Verbindungselement 42 eine weitere Kederschiene 45 vorgesehen, in welcher ein weiteres Kederelement 46 am zugehörigen Längsrand des Dichtfolienstreifens 36 dichtend aufgenommen ist.

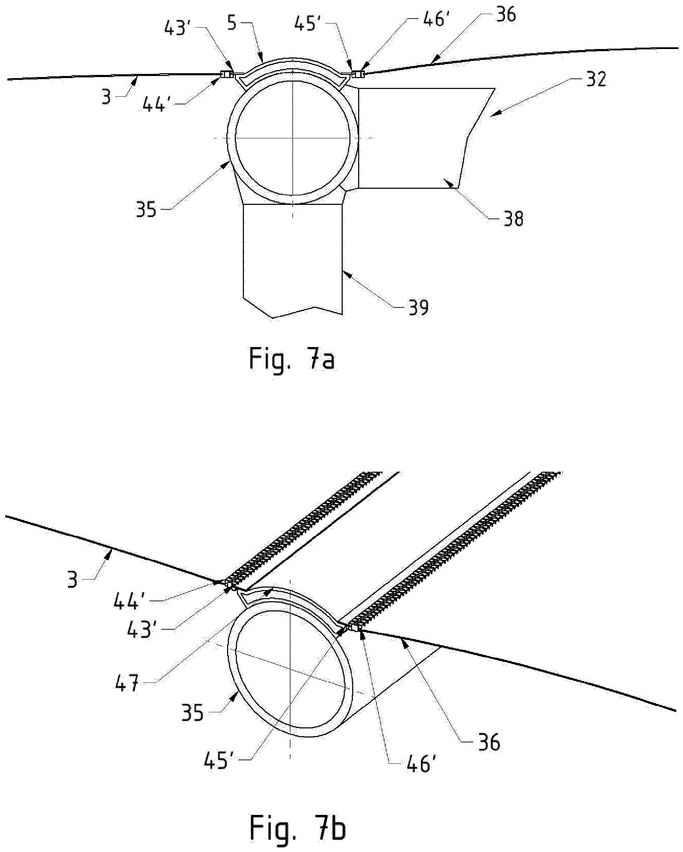

Fig. 7a, 7b zeigen eine alternative Ausführung der Verbindung zwischen dem oberen Längsträger 32 und dem Deckfolienelement 3". Bei dieser Ausführung ist als Verbindungselement 41 ein Reißverschlusselement 43' zur Verbindung mit einem entsprechenden Reißverschlusselement 44' an einem der Längsränder des Deckfolienelements 3". Entsprechend ist als weiteres Verbindungselement 42 ein weiteres Reißverschlusselement 45' zur Verbindung mit einem entsprechenden weiteren Reißverschlusselement 46' des Dichtfolienstreifens 36 vorgesehen. Die Reißverschlusselemente 43', 45' sind auf der Oberseite eines in Längsrichtung des Konzentrator-Kissens 2 erstreckten Profils 47 angeordnet, welches oberseitig an dem Längsgurt 35 des oberen Längsträgers 32 angebracht ist.

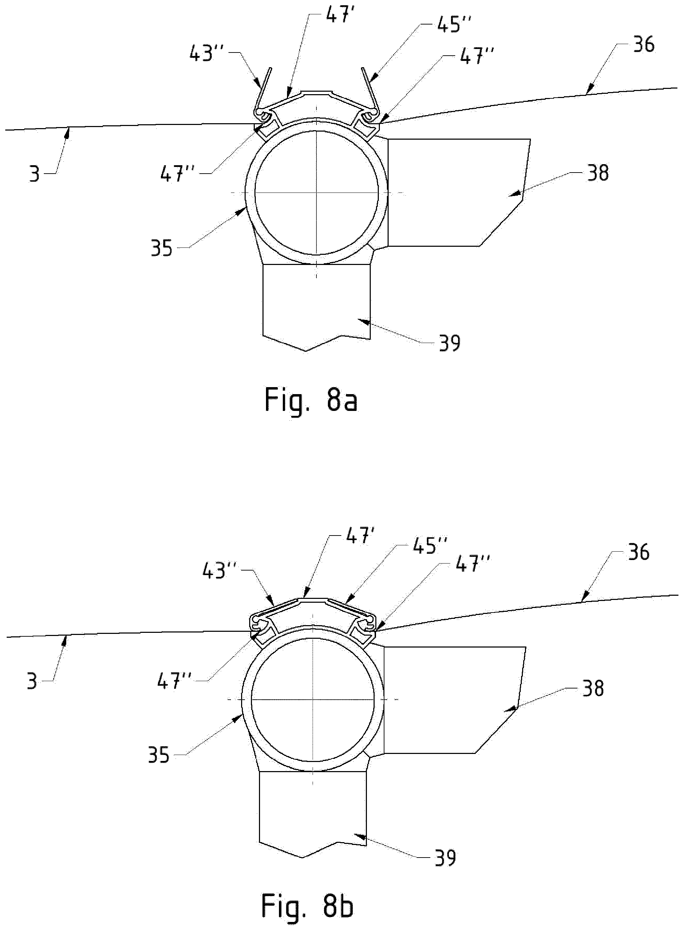

In Fig. 8 ist eine weitere alternative Ausführung gezeigt, bei welcher als Verbindungselement 41 ein Klemmteil 43" zum Festklemmen des zugehörigen Längsrandes des Deckfolienelements 3" vorgesehen ist. Entsprechend ist als weiteres Verbindungselement 42 ein weiteres Klemmteil 45" zum Festklemmen des zugehörigen Längsrandes des Dichtfolienstreifens 36 vorgesehen. Zu diesem Zweck ist ein in Längsrichtung des Konzentrator-Kissens 2 erstrecktes Profilteil 47' auf der Oberseite des Längsgurtes 35 vorgesehen. Das Profilteil 47' weist Lagerflächen 47" auf, welche mit dem Klemmteil 43" bzw. dem weiteren Klemmteil 45" zusammenwirken. Das Klemmteil 43" ist zwischen einer den Längsrand des Deckfolienelements 3" freigebenden Stellung (vgl. Fig. 8a) und einer den Längsrand des Deckfolienelements 3" festklemmenden Stellung (vgl. Fig. 8b) verschwenkbar. Entsprechend ist das weitere Klemmteil 45" zwischen einer den Längsrand des des Dichtfolienstreifens 36 freigebenden Stellung (vgl. Fig. 8a) und einer den Längsrand des Dichtfolienstreifens 36 festklemmenden Stellung (vgl. Fig. 8b) verschwenkbar.

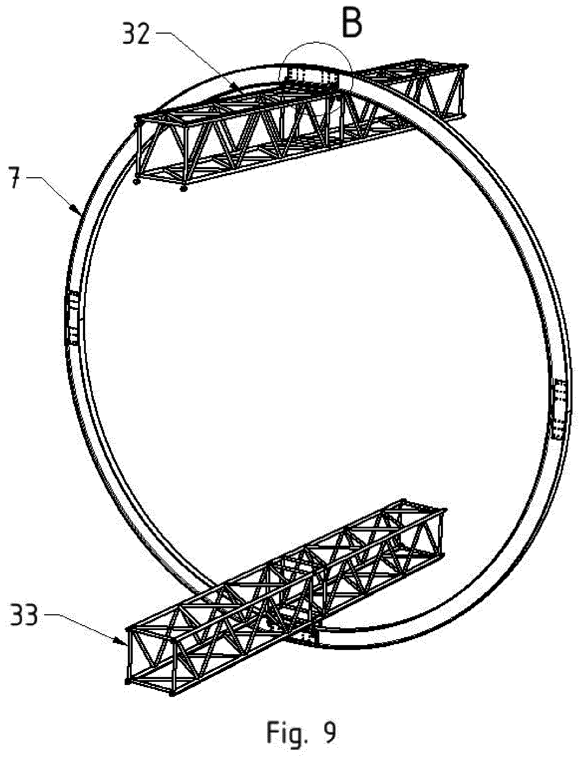

Wie aus Fig. 9 ersichtlich, ist zwischen dem oberen Längsträger 32 der Halteeinrichtung 31 und der Schwenkeinrichtung 7 eine Verstelleinrichtung 48 vorgesehen, mit welcher der Abstand zwischen dem oberen Längsträger 32 und der Schwenkeinrichtung 7 einstellbar ist. Eine weitere Verstelleinrichtung ist zwischen dem unteren Längsträger 32 und der Schwenkeinrichtung 7 vorgesehen, wobei sich nachfolgende Erläuterungen zur Verstelleinrichtung 48 für den oberen Längsträger 32 entsprechend auf die Verstellung des unteren Längsträgers 33 beziehen sollen. Die Verstelleinrichtung 48 ist einerseits mit beiden Längsgurten 35 des oberen Längsträgers 32 und andererseits mit einem horizontalen Befestigungsflansch 49 verbunden ist.

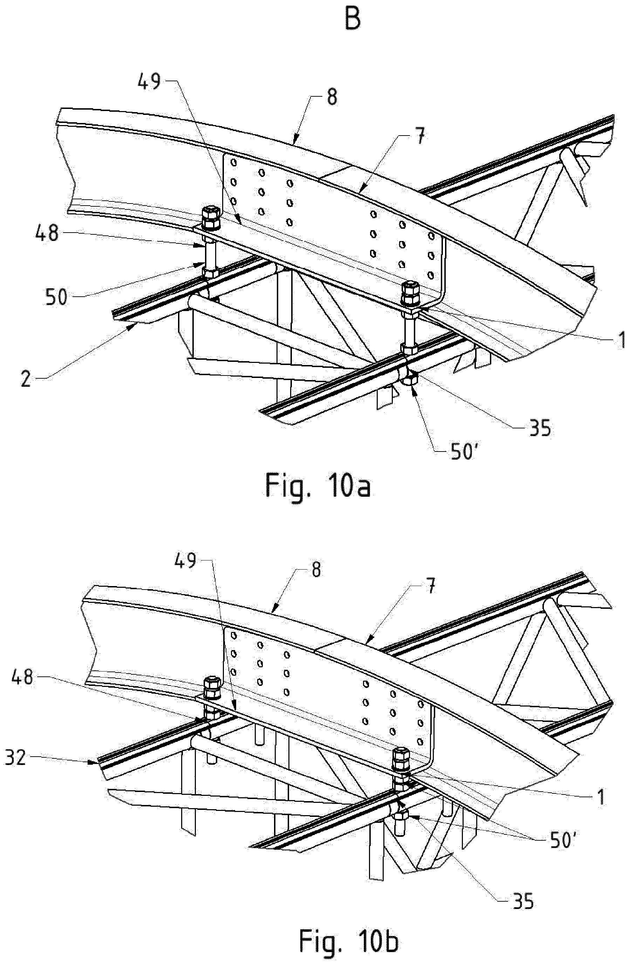

Gemäß Fig. 10 weist die Verstelleinrichtung 48 ein Verstellelement in Form einer Gewindestange 50 auf, welche mit Gewindemuttern 50' zusammenwirkt, um den Abstand zwischen dem oberen Längsträger 32 und der Schwenkeinrichtung 7 manuell einstellen zu können. Die Gewindestange 50 ist in der Ausführung der Fig. 10 im Wesentlichen senkrecht zur Längsrichtung des oberen Längsträgers 32 angeordnet. Die Längsgurte 35 des oberen Längsträgers 32 sind jeweils mit zumindest einer Gewindestange 50 verbunden.

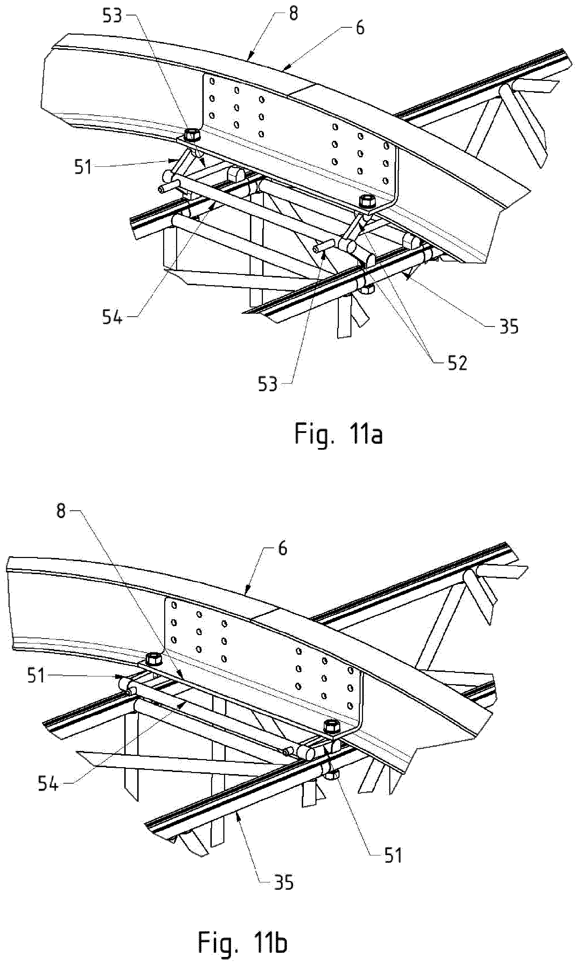

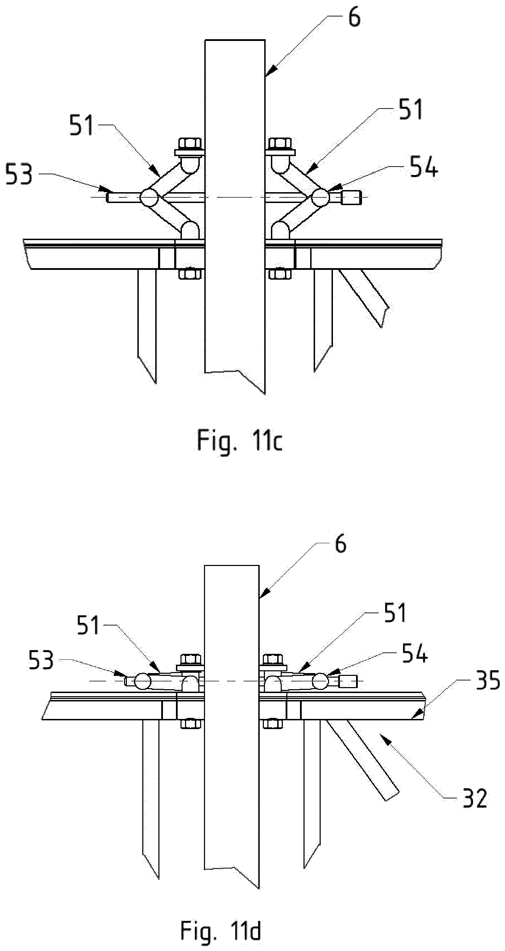

Gemäß Fig. 11 sind zwischen dem oberen Längsträger 32 und der Schwenkeinrichtung 7 mehrere Kniehebelelemente 51 angeordnet, welche an deren Enden gelenkig miteinander verbundene Schenkelteile 52 aufweisen. Zur Einstellung des Abstands zwischen der Schwenkeinrichtung 7 und dem oberen Längsträger 32 wird der Öffnungswinkel zwischen den Schenkelteilen 52 der Kniehebelelemente 51 angepasst. In der gezeigten Ausführung sind an beiden Längsgurten 35 jeweils zwei in Längsrichtung beabstandete Kniehebelelemente 51 befestigt, welche über zumindest ein Einstellelement 53 in Form einer Gewindestange miteinander gekoppelt sind. Durch Verstellung der Gewindestange kann der Öffnungswinkel der Kniehebelelemente 51 und damit der Abstand zwischen der Schwenkeinrichtung 7 und dem oberen Längsträger 32 eingestellt werden. In der gezeigten Ausführung sind zwei Einstellelemente 53 im Wesentlichen parallel zur Längsrichtung des oberen Längsträgers 32 horizontal angeordnet.

Wie aus Fig. 11 weiters ersichtlich, sind die Kniehebelelemente 53 an den gegenüberliegenden Längsgurten 35 des oberen Längsträgers 32 paarweise über Verbindungsstangen 54 miteinander verbunden. In der gezeigten Ausführung sind zwei Einstellelemente 53 in Form von Gewindestangen vorgesehen, welche verstellbar mit den Verbindungsstangen 54 verbunden sind.

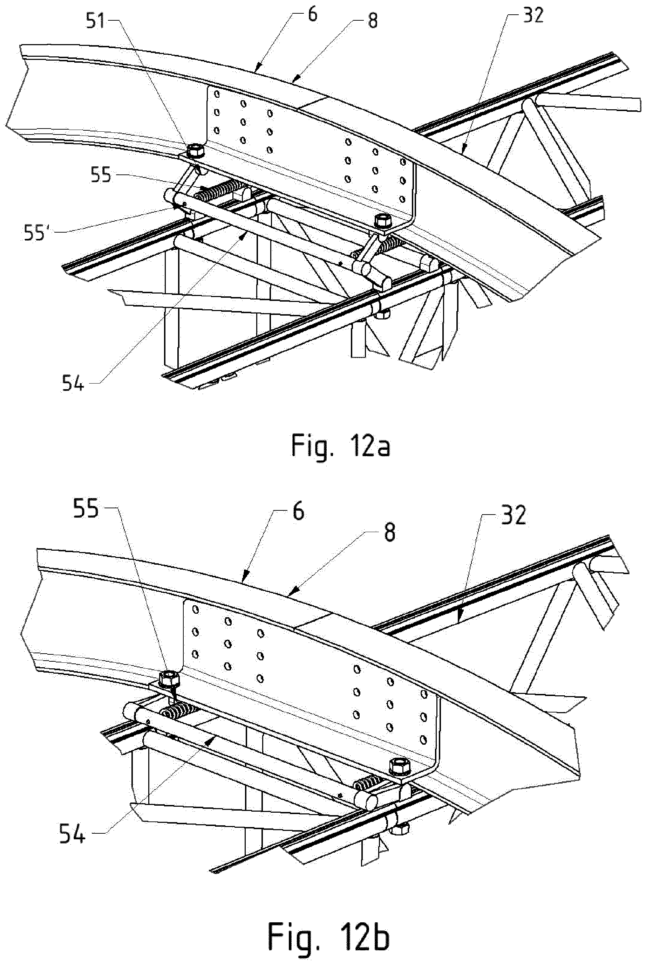

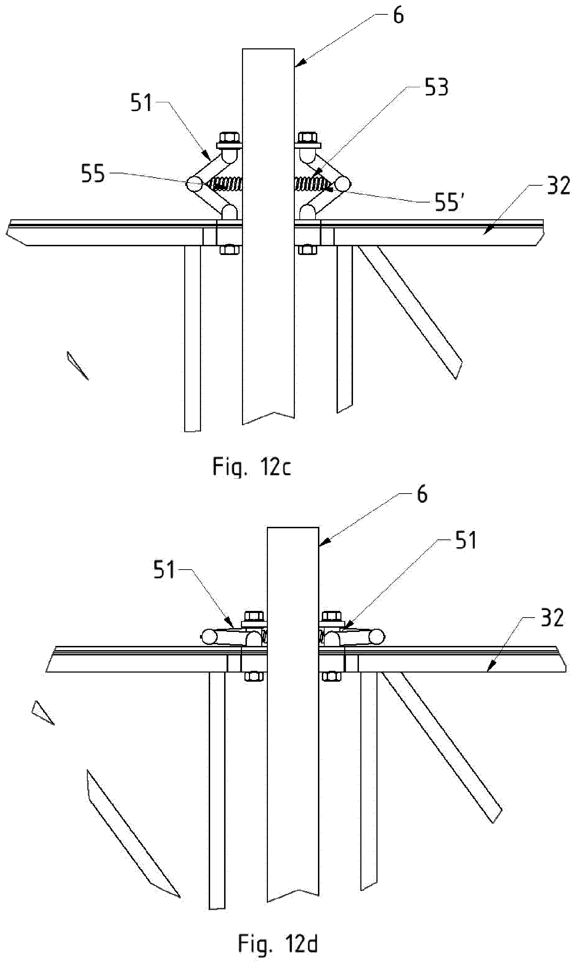

Gemäß Fig. 12 weist die Verstelleinrichtung 48 ein Antriebselement 55 auf, mit welchem der Abstand zwischen der Schwenkeinrichtung 7 und dem oberen Längsträger 32 abhängig von einem Lastzustand des oberen Längsträgers 32 (d.h. insbesondere abhängig von einer vertikalen Kraft infolge des Kriechens des Konzentrator-Kissens 2) selbsttätig nachstellbar ist. Als Antriebselement 55 ist ein Federelement 55' derart vorgesehen, dass der obere Längsträger 32 je nach Lastzustand des oberen Längsträgers 32 gegen die Kraft des Federelements 55' näher an den Schwenkring 8 heranführbar ist. In der gezeigten Ausführung sind die Einstellelemente 53 zwischen den Verbindungsstangen 54 als Antriebselemente 55 ausgebildet.

## Patentansprüche

1. Vorrichtung (1) zur Konzentration von Sonnenstrahlung in einem Absorber (1'), mit einem aufblasbaren Konzentrator-Kissen (2), welches ein Deckfolienelement (3'') mit einem lichtdurchlässigen Eintrittsfenster (3) zum Einkoppeln von Sonnenstrahlung und eine das Konzentrator-Kissen (2) in zumindest zwei Hohlräume (4, 5) unterteilende Reflektorfolie (6) zum Konzentrieren der Sonnenstrahlung in einem Absorber (1') aufweist, mit einer Schwenkeinrichtung (7), mit welcher das Konzentrator-Kissen (2) insbesondere um dessen Längsachse verschwenkbar ist, und mit einer an der Schwenkeinrichtung (7) montierten Halteeinrichtung (31) zur Halterung des Konzentrator-Kissens (2), welche Halteeinrichtung (31) einen in Längsrichtung des Konzentrator-Kissens (2) erstreckten oberen Längsträger (32) zur Aufhängung des Absorbers (1') aufweist, wobei der obere Längsträger (32) an einer im Wesentlichen luftdicht verschlossenen oberen Durchtrittsöffnung (34) des Konzentrator-Kissens (2) angeordnet ist, **dadurch gekennzeichnet, dass** zwischen dem oberen Längsträger (32) der Halteeinrichtung (31) und der Schwenkeinrichtung (7) eine Verstelleinrichtung (48) vorgesehen ist, mit welcher der Abstand zwischen dem oberen Längsträger (32) und der Schwenkeinrichtung (7) einstellbar ist.

2. Vorrichtung (1) nach Anspruch 1, **dadurch gekennzeichnet, dass** der obere Längsträger (32) zumindest zwei in Längsrichtung des Konzentrator-Kissens (2) erstreckte, insbesondere über Füllstäbe (38) miteinander verbundene Längsgurte (35) aufweist, welche jeweils mit einem die obere Durchtrittsöffnung (34) begrenzenden Längsrand des Deckfolienelements (3'') verbunden sind, wobei die Verstelleinrichtung (48) mit einem der Längsgurte (35) des oberen Längsträgers (32), vorzugsweise mit beiden Längsgurten (35) des oberen Längsträgers (32), verbunden ist.

3. Vorrichtung (1) nach Anspruch 1 oder 2, **dadurch gekennzeichnet, dass** die Verstelleinrichtung (48) zur Einstellung des Abstands zwischen dem oberen Längsträger (32) und der Schwenkeinrichtung (7) ein insbesondere im Wesentlichen senkrecht zur Längsrichtung des oberen Längsträgers (32) angeordnetes Verstellelement, insbesondere eine Gewindestange (50), aufweist.

4. Vorrichtung (1) nach einem der Ansprüche 1 bis 3, **dadurch gekennzeichnet, dass** zwischen dem oberen Längsträger (32) und der Schwenkeinrichtung (7) zumindest ein Kniehebelelement (51) mit zwei gelenkig miteinander verbundenen Schenkelteilen (52) angeordnet ist, wobei ein Öffnungswinkel zwischen den Schenkelteilen (52) des Kniehebelelements (51) zur Einstellung des Abstands zwischen der Schwenkeinrichtung (7) und dem oberen Längsträger (32) veränderbar ist.

5. Vorrichtung (1) nach Anspruch 4, **dadurch gekennzeichnet, dass** das zumindest eine Kniehebelelement (51) zur Veränderung des Öffnungswinkels mit einem Einstellelement (53) gekoppelt ist, welches vorzugsweise im Wesentlichen parallel zur Längsrichtung des oberen Längsträgers (32) angeordnet ist.

6. Vorrichtung (1) nach Anspruch 4 oder 5, **dadurch gekennzeichnet, dass** zwei an den Längsgurten (35) des oberen Längsträgers (32) angeordnete Kniehebelelemente (51) über eine Verbindungsstange (54) miteinander verbunden sind, an welcher vorzugsweise das Einstellelement (53) angreift.

7. Vorrichtung (1) nach einem der Ansprüche 4 bis 6, **dadurch gekennzeichnet, dass** an jedem Längsgurt (35) zwei in Längsrichtung des oberen Längsträgers (32) beabstandete, vorzugsweise über das Einstellelement (53) miteinander gekoppelte Kniehebelelemente (51) befestigt sind.

8. Vorrichtung (1) nach einem der Ansprüche 1 bis 7, **dadurch gekennzeichnet, dass** die Verstelleinrichtung (48) ein Antriebselement (55) aufweist, mit welchem der Abstand zwischen der Schwenkeinrichtung (7) und dem oberen Längsträger (32) abhängig von einem Lastzustand des oberen Längsträgers (32) selbsttätig nachstellbar ist.

9. Vorrichtung (1) nach Anspruch 8, **dadurch gekennzeichnet, dass** als Antriebselement (55) ein Federelement (55') vorgesehen ist, wobei der Abstand zwischen der Schwenkeinrichtung (7) und dem oberen Längsträger (32) abhängig vom Lastzustand des oberen Längsträgers (32) gegen die Kraft des Federelements (55') einstellbar ist.

10. Vorrichtung (1) nach einem der Ansprüche 1 bis 9, **dadurch gekennzeichnet, dass** die Schwenkeinrichtung (7) zumindest ein das Konzentrator-Kissen (2) in dessen Umfangsrichtung umschließendes Schwenkelement, insbesondere einen Schwenkring (8), aufweist, wobei der obere Längsträger (32) der Halteeinrichtung (31) mittels der Verstelleinrichtung (48) an dem Schwenkelement aufgehängt ist.

11. Vorrichtung (1) nach Anspruch 10, **dadurch gekennzeichnet, dass** mehrere in Längsrichtung des Konzentrator-Kissens (2) beabstandete Schwenkelemente, insbesondere Schwenkringe (8), vorgesehen sind, an welchen der obere Längsträger (32) der Halteeinrichtung (31) für den Absorber (1') aufgehängt ist, wobei zwischen dem oberen Längsträger (32) und den Schwenkelementen, insbesondere Schwenkringen (8), jeweils eine Verstelleinrichtung (48) vorgesehen ist.

12. Vorrichtung (1) nach einem der Ansprüche 1 bis 11, **dadurch gekennzeichnet, dass** ein unterer Längsträger (33) der Halteeinrichtung (31) an einer im Wesentlichen luftdicht verschlossenen unteren Durchtrittsöffnung (34) des Konzentrator-Kissens (2) angeordnet ist, wobei zwischen dem unteren Längsträger (33) der Halteeinrichtung (31) und der Schwenkeinrichtung (7) eine weitere Verstelleinrichtung (48) zur Einstellung des Abstands zwischen dem unteren Längsträger (33) und der Schwenkeinrichtung (7) vorgesehen ist.

13. Vorrichtung (1) nach einem der Ansprüche 1 bis 12, **dadurch gekennzeichnet, dass** eine Verankerungseinrichtung (9) zur Verankerung der Schwenkeinrichtung (7) an einer Bodenstruktur vorgesehen ist, welche vorzugsweise eine Aufhängeeinrichtung (10) zum Aufhängen der Schwenkeinrichtung (7) aufweist.

14. Vorrichtung (1) nach Anspruch 13, **dadurch gekennzeichnet, dass** zwischen der Aufhängeeinrichtung (10) und der Schwenkeinrichtung (7) eine Schwenklagereinrichtung (18), insbesondere eine Rollenlagerung (19), (20), vorgesehen ist.

## Claims

1. Device (1) for concentrating solar radiation in an absorber (1'), comprising an inflatable concentrator cushion (2) which comprises a cover film element (3") having a translucent inlet window (3) for coupling in solar radiation and a reflector film (6) for concentrating the solar radiation in an absorber (1'), which reflector film divides the concentrator cushion (2) into at least two cavities (4, 5), comprising a pivot means (7) by means of which the concentrator cushion (2) can be pivoted, in particular about the longitudinal axis thereof, and comprising a retaining means (31) mounted on the pivot means (7) for retaining the concentrator cushion (2), which retaining means (31) comprises an upper longitudinal support (32) that extends in the longitudinal direction of the concentrator cushion (2) for suspending the absorber (1'), the upper longitudinal support (32) being arranged at an upper through-opening (34), which is substantially hermetically sealed, in the concentrator cushion (2), **characterised in that** an adjustment means (48) is provided between the upper longitudinal support (32) of the retaining means (31) and the pivot means (7), by means of which adjustment means the distance between the upper longitudinal support (32) and the pivot means (7) can be adjusted.

2. Device (1) according to claim 1, **characterised in that** the upper longitudinal support (32) comprises at least two longitudinal chords (35) which are interconnected by cross bars (38), extend in the longitudinal direction of the concentrator cushion (2) and are each connected to a longitudinal edge, delimiting the upper through-opening (34), of the cover film element (3"), the adjustment means (48) being connected to one of the longitudinal chords (35) of the upper longitudinal support (32), preferably to both longitudinal chords (35) of the upper longitudinal support (32).

3. Device (1) according to either claim 1 or claim 2, **characterised in that** the adjustment means (48) for adjusting the distance between the upper longitudinal support (32) and the pivot means (7) comprises an adjustment element, in particular a threaded rod (50), that is arranged in particular substantially perpendicular to the longitudinal direction of the upper longitudinal support (32).

4. Device (1) according to any of claims 1 to 3, **characterised in that** at least one toggle joint element (51) having two hingedly interconnected pivot parts (52) is arranged between the upper longitudinal support (32) and the pivot means (7), an opening angle between the pivot parts (52) of the toggle joint element (51) being variable in order to adjust the distance between the pivot means (7) and the upper longitudinal support (32).

5. Device (1) according to claim 4, **characterised in that**, in order to change the opening angle, the at least one toggle joint element (51) is coupled to an adjusting element (53) which is preferably arranged substantially parallel to the longitudinal direction of the upper longitudinal support (32).

6. Device (1) according to either claim 4 or claim 5, **characterised in that** two toggle joint elements (51) arranged on the longitudinal chords (35) of the upper longitudinal support (32) are interconnected by means of a connecting rod (54) with which the adjusting element (53) preferably engages.

7. Device (1) according to any of claims 4 to 6, **characterised in that** two toggle joint elements (51) that are spaced apart in the longitudinal direction of the upper longitudinal support (32) and are preferably intercoupled by means of the adjusting element (53) are fastened to each longitudinal chord (35).

8. Device (1) according to any of claims 1 to 7, **characterised in that** the adjustment means (48) comprises a drive element (55) by means of which the distance between the pivot means (7) and the upper longitudinal support (32) can be automatically readjusted depending on a load condition of the upper longitudinal support (32).

9. Device (1) according to claim 8, **characterised in that** a spring element (55') is provided as the drive element (55), it being possible to adjust the distance between the pivot means (7) and the upper longitudinal support (32) against the force of the spring element (55') depending on the load condition of the upper longitudinal support (32).

10. Device (1) according to any of claims 1 to 9, **characterised in that** the pivot means (7) comprises at least one pivot element, in particular a pivot ring (8), that surrounds the concentrator cushion (2) in the circumferential direction thereof, the upper longitudinal support (32) of the retaining means (31) being suspended from the pivot element by means of the adjustment means (48).

11. Device (1) according to claim 10, **characterised in that** a plurality of pivot elements, in particular pivot rings (8), that are spaced apart in the longitudinal direction of the concentrator cushion (2) are provided, from which the upper longitudinal support (32) of the retaining means (31) for the absorber (1') is suspended, an adjustment means (48) being provided in each case between the upper longitudinal support (32) and the pivot elements, in particular pivot rings (8).

12. Device (1) according to any of claims 1 to 11, **characterised in that** a lower longitudinal support (33) of the retaining means (31) is arranged at a substantially hermetically sealed lower through-opening (34) in the concentrator cushion (2), an additional adjustment means (48) for adjusting the distance between the lower longitudinal support (33) and the pivot means (7) being provided between the lower longitudinal support (33) of the retaining means (31) and the pivot means (7).

13. Device (1) according to any of claims 1 to 12, **characterised in that** an anchoring means (9) is provided for anchoring the pivot means (7) to a base structure, which anchoring means preferably comprises a suspension means (10) for suspending the pivot means (7).

14. Device (1) according to claim 13, **characterised in that** a pivot bearing means (18), in particular a roller bearing (19), (20), is provided between the suspension means (10) and the pivot means (7).

## Revendications

1. Dispositif (1) pour la concentration du rayonnement solaire dans un absorbeur (1'), avec un coussin de concentrateur gonflable (2), qui comprend un élément à film de recouvrement (3") avec une fenêtre d'entrée transparente (3) pour l'entrée d'un rayonnement solaire et un film réflecteur (6) divisant le coussin de concentrateur (2) en au moins deux cavités (4, 5) pour la concentration du rayonnement solaire dans un absorbeur (1'), avec un dispositif de pivotement (7), avec lequel le coussin de concentrateur (2) peut pivoter plus particulièrement autour de son axe longitudinal et avec un dispositif de maintien (31), monté sur le dispositif de pivotement (7), pour le maintien du coussin de concentrateur (2), ce dispositif de maintien (31) comprenant un support longitudinal supérieur (32) s'étendant dans la direction longitudinale du coussin de concentrateur (2) pour la suspension de l'absorbeur (1'), le support longitudinal supérieur (32) étant disposé au niveau d'une ouverture de passage supérieure (34) du coussin de concentrateur (2), fermée de manière globalement étanche à l'air, **caractérisé en ce que**, entre le support longitudinal supérieur (32) du dispositif de maintien (31) et le dispositif de pivotement (7), est prévu un dispositif de réglage (48) qui permet de régler la distance entre le support longitudinal supérieur (32) et le dispositif de pivotement (7).

2. Dispositif (1) selon la revendication 1, **caractérisé en ce que** le support longitudinal supérieur (32) comprend au moins deux sangles longitudinales (35) s'étendant dans la direction longitudinale du coussin de concentrateur (2), plus particulièrement reliées entre elles par des tiges de remplissage (38), qui sont reliées chacune avec un bord longitudinal de l'élément de film de recouvrement (3") délimitant l'ouverture de passage supérieure (34), le dispositif de réglage (48) étant relié avec une des sangles longitudinales (35) du support longitudinal supérieur (32), de préférence avec les deux sangles longitudinales (35) du support longitudinal supérieur (32).

3. Dispositif (1) selon la revendication 1 ou 2, **caractérisé en ce que** le dispositif de réglage (48) comprend, pour le réglage de la distance entre le support longitudinal supérieur (32) et le dispositif de pivotement (7), un élément de réglage disposé plus particulièrement globalement perpendiculairement à la direction longitudinale du support longitudinal supérieur (32), plus particulièrement, une tige filetée (50).

4. Dispositif (1) selon l'une des revendications 1 à 3, **caractérisé en ce que**, entre le support longitudinal supérieur (32) et le dispositif de pivotement (7), est disposé au moins un élément de levier basculant (51) avec deux parties (52) reliées entre elles de manière articulée, un angle d'ouverture entre les parties (52) de l'élément de levier basculant (51) pouvant être modifié pour le réglage de la distance entre le dispositif de pivotement (7) et le support longitudinal supérieur (32).

5. Dispositif (1) selon la revendication 4, **caractérisé en ce que** l'au moins un élément de levier basculant (51) est couplé, pour la modification de l'angle d'ouverture, avec un élément de réglage (53) qui est disposé, de préférence globalement parallèlement à la direction longitudinale du support longitudinal supérieur (32).

6. Dispositif (1) selon la revendication 4 ou 5, **caractérisé en ce que** deux éléments de levier basculant (51), disposés au niveau des sangles longitudinales (35) du support longitudinal supérieur (32), sont reliés entre eux par l'intermédiaire d'une tige de liaison (54), au niveau de laquelle s'emboîte de préférence l'élément de réglage (53).

7. Dispositif (1) selon l'une des revendications 4 à 6, **caractérisé en ce que**, au niveau de chaque sangle longitudinale (35), sont fixés deux éléments de levier basculant (51) distants dans la direction longitudinale du support longitudinal supérieur (32), de préférence couplés entre eux par l'intermédiaire de l'élément de réglage (53).

8. Dispositif (1) selon l'une des revendications 1 à 7, **caractérisé en ce que** le dispositif de réglage (48) comprend un élément d'entraînement (55) avec lequel la distance entre le dispositif de pivotement (7) et le support longitudinal supérieur (32) peut être réajustée automatiquement en fonction d'un état de charge du support longitudinal supérieur (32).

9. Dispositif (1) selon la revendication 8, **caractérisé en ce que** l'élément d'entraînement (55) utilisé est un élément de ressort (55'), la distance entre le dispositif de pivotement (7) et le support longitudinal supérieur (32) pouvant être réglée en fonction de l'état de charge du support longitudinal supérieur (32) contre la force de l'élément de ressort (55').

10. Dispositif (1) selon l'une des revendications 1 à 9, **caractérisé en ce que** le dispositif de pivotement (7) comprend au moins un élément de pivotement entourant le coussin de concentrateur (2) sur sa circonférence, plus particulièrement une bague de pivotement (8), le support longitudinal supérieur (32) du dispositif de maintien (31) étant suspendu à l'élément de pivotement au moyen du dispositif de réglage (48).

11. Dispositif (1) selon la revendication 10, **caractérisé en ce que** plusieurs éléments de pivotement distants dans la direction longitudinale du coussin de concentrateur (2), plus particulièrement des bagues de pivotement (8), sont prévus, au niveau desquels le support longitudinal supérieur (32) du dispositif de maintien (31) pour l'absorbeur (1') est suspendu, un dispositif de réglage (48) étant prévu entre le support longitudinal supérieur (32) et chacun des éléments de pivotement, plus particulièrement des bagues de pivotement (8).

12. Dispositif (1) selon l'une des revendications 1 à 11, **caractérisé en ce qu'**un support longitudinal inférieur (33) du dispositif de maintien (31) est disposé au niveau d'une ouverture de passage inférieure (34), fermée de manière globalement étanche à l'air, du coussin de concentrateur (2), un dispositif de réglage supplémentaire (48) étant prévu entre le support longitudinal inférieur (33) du dispositif de maintien (31) et le dispositif de pivotement (7), pour le réglage de la distance entre le support longitudinal inférieur (33) et le dispositif de pivotement (7).

13. Dispositif (1) selon l'une des revendications 1 à 12, **caractérisé en ce qu'**un dispositif d'ancrage (9) pour l'ancrage du dispositif de pivotement (7) à une structure au sol, qui comprend de préférence un dispositif de suspension (10) pour la suspension du dispositif de pivotement (7).

14. Dispositif (1) selon la revendication 13, **caractérisé en ce que**, entre le dispositif de suspension (10) et le dispositif de pivotement (7) est prévu un dispositif à palier de pivotement (18), plus particulièrement un palier à rouleaux (19), (20).
